(19) **Europäisches Patentamt / European Patent Office / Office européen des brevets**

(11) **EP 4 391 389 B1**

(12) **EUROPEAN PATENT SPECIFICATION**

(45) Date of publication and mention
of the grant of the patent:
**04.02.2026  Bulletin 2026/06**

(21) Application number: **23805849.9**

(22) Date of filing: **19.07.2023**

(51) International Patent Classification (IPC):
$H03M\ 1/10^{(2006.01)}$    $H03M\ 1/08^{(2006.01)}$
$H03M\ 1/16^{(2006.01)}$    $H03M\ 1/40^{(2006.01)}$
$H03M\ 3/00^{(2006.01)}$

(52) Cooperative Patent Classification (CPC):
**H03M 1/10; H03M 1/089; H03M 1/12; H03M 1/164;
H03M 1/403; H03M 3/43; H03M 3/464**

(86) International application number:
**PCT/CN2023/108062**

(87) International publication number:
**WO 2024/082732 (25.04.2024 Gazette 2024/17)**

(54) **ANALOG-TO-DIGITAL CONVERTER INTEGRATED WITH REFERENCE VOLTAGE GENERATION, AND CALIBRATION METHOD**

ANALOG-DIGITAL-WANDLER MIT INTEGRIERTER REFERENZSPANNUNGSERZEUGUNG UND KALIBRIERUNGSVERFAHREN

CONVERTISSEUR ANALOGIQUE-NUMÉRIQUE INTÉGRÉ AVEC GÉNÉRATION DE TENSION DE RÉFÉRENCE, ET PROCÉDÉ D'ÉTALONNAGE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **01.06.2023  CN 202310643748**

(43) Date of publication of application:
**26.06.2024  Bulletin 2024/26**

(73) Proprietor: **Hangzhou Vango Technologies, Inc.
Hangzhou, Zhejiang 310053 (CN)**

(72) Inventors:
• **TANG, Zhong**
  **Hangzhou, Zhejiang 310053 (CN)**
• **LIU, Yuyan**
  **Hangzhou, Zhejiang 310053 (CN)**
• **TAN, Nianxiong**
  **Hangzhou, Zhejiang 310053 (CN)**

(74) Representative: **HGF**
  **HGF Limited**
  **4th Floor, 1 City Square**
  **Leeds LS1 2AL (GB)**

(56) References cited:
CN-A- 102 404 007    CN-A- 112 953 535
CN-A- 113 791 661    CN-U- 202 929 513
US-A1- 2008 018 514   US-A1- 2020 373 940
US-A1- 2020 373 940

• TANG ZHONG ET AL: "An Energy-Efficient Capacitively Biased Diode-Based Temperature Sensor in 55-nm CMOS", IEEE SOLID-STATE CIRCUITS LETTERS, IEEE, vol. 4, 1 November 2021 (2021-11-01), pages 210 - 213, XP011887540, DOI: 10.1109/LSSC.2021.3124471
• EBERLEIN M ET AL: "Time-Controlled and FinFET Compatible Sub-Bandgap References Using Bulk-Diodes", IEEE TRANSACTIONS ON CIRCUITS AND SYSTEMS II: EXPRESS BRIEFS, IEEE, USA, vol. 66, no. 10, 1 October 2019 (2019-10-01), pages 1608 - 1612, XP011747685, ISSN: 1549-7747, [retrieved on 20190923], DOI: 10.1109/TCSII.2019.2929599

**EP 4 391 389 B1**

**(Cont. next page)**

- **TANG ZHONG ET AL: "3.4 A 14b 98Hz-to-5.9kHz 1.7-to-50.8 [mu] W BW/Power Scalable Sensor Interface with a Dynamic Bandgap Reference and an Untrimmed Gain Error of 0.26 % from -40�C to 125�C", 2024 IEEE INTERNATIONAL SOLID-STATE CIRCUITS CONFERENCE (ISSCC), IEEE, vol. 67, 18 February 2024 (2024-02-18), pages 60 - 62, XP034562138, DOI: 10.1109/ ISSCC49657.2024.10454378**

## Description

## TECHNICAL FIELD

The present invention belongs to the field of analog to digital conversion technologies, and particularly to an analog to digital converter integrated with reference voltage generation and a calibration method.

## BACKGROUND

High-precision sensor applications require a high-precision Analog to Digital Converter (ADC) to collect input signals, and also require a high-precision reference source that does not change with temperature, power supply and other environments as a reference signal of the ADC. In addition, an extra reference signal driver is required to drive the ADC. In conventional designs, a reference signal generation module, a driver, and an analog to digital converter are often designed separately, which inevitably has defects such as high power consumption, large area, and high error. In order to achieve high precision, each component needs to be calibrated separately, which increases calibration costs.

US patent application US 2020/0373940 A1 discloses a dynamic voltage reference for analog-to-digital converters with temperature trim calibration.

## SUMMARY

Object of the present invention: the technical problem to be solved by the present invention is to provide an analog to digital converter integrated with reference voltage generation and a calibration method for the deficiencies of the prior art.

In order to solve the above technical problems, a first aspect discloses an analog to digital converter integrated with reference voltage generation, comprising a sample-hold circuit, a capacitive digital to analog converter and a quantizer, wherein:

the sample-and-hold circuit is configured for sampling and holding an analog input signal to obtain a first signal;
the capacitive digital to analog converter is configured for generating a reference signal and generating a second signal in equal proportion to the reference signal according to a feedback digital output signal, and differencing the first signal and the second signal to obtain an error signal; and
the quantizer is configured for digitizing the error signal to obtain a digital output signal.

Optionally, in some analog to digital converters, a loop filter may be added in front of the quantizer, and the loop filter is configured for noise shaping to improve a resolution.

Further, the capacitive digital to analog converter comprises a CTAT circuit based on a capacitively-biased diode and a PTAT circuit based on a capacitively-biased diode, the CTAT circuit based on the capacitively-biased diode and the PTAT circuit based on the capacitively-biased diode jointly generate the reference signal, and the reference signal is independent of temperature.

Further, the CTAT circuit based on the capacitively-biased diode generates a CTAT voltage $V_D$ which decreases with the increase of temperature, and the PTAT circuit based on the capacitively-biased diode generates a PTAT voltage $\Delta V_D$ which increases with the increase of temperature, the CTAT voltage $V_D$ and the PTAT voltage $\Delta V_D$ are combined and added to generate a reference voltage $V_{REF}$ of the reference signal, $V_{REF}=\alpha\Delta V_D+V_D$, $\alpha$ is a scale factor, and a value of the scale factor $\alpha$ makes the reference voltage $V_{REF}$ independent of temperature.

Further, the CTAT circuit based on the capacitively-biased diode comprises a first CTAT circuit switch $S_{CTAT1}$, a CTAT diode branch and a CTAT capacitor branch, one end of the first CTAT circuit switch $S_{CTAT1}$ is connected to one end of the CTAT diode branch and one end of the CTAT capacitor branch respectively, and the other end of the CTAT diode branch and the other end of the CTAT capacitor branch are both grounded; and the other end of the first CTAT circuit switch $S_{CTAT1}$ is connected to a power supply.

Further, the PTAT circuit based on the capacitively-biased diode comprises a first capacitively-biased diode circuit and a second capacitively-biased diode circuit, the first capacitively-biased diode circuit comprises a first PTAT circuit switch $S_{PTAT1}$, a first PTAT diode branch and a first PTAT capacitor branch, one end of the first PTAT circuit switch $S_{PTAT1}$ is respectively connected to one end of the first PTAT diode branch and one end of the first PTAT capacitor branch, and the other end of the first PTAT diode branch and the other end of the first PTAT capacitor branch are both grounded; and the other end of the first PTAT circuit switch $S_{PTAT1}$ is connected to the power supply; and
the second capacitively-biased diode circuit comprises a second PTAT circuit switch $S_{PTAT2}$, a second PTAT diode branch and a second PTAT capacitor branch, one end of the second PTAT circuit switch $S_{PTAT2}$ is connected to one end of the second PTAT diode branch and one end of the second PTAT capacitor branch respectively, and the other end of the second PTAT diode branch and the other end of the second PTAT capacitor branch are both grounded; and the other end of the second PTAT circuit switch $S_{PTAT2}$ is connected to the power supply.

Further, the CTAT diode branch comprises a first diode D1 and a second CTAT circuit switch $S_{CTAT2}$ connected to the first diode D1.

Further, when the digital output signal is a 1-bit digital output, the CTAT capacitor branch comprises a second reference capacitor $C_{REF2}$.

Further, when the digital output signal is an *N-bit* output, and *N* is greater than 1, the CTAT capacitor branch comprises $N$ parallel second capacitor branches, the second capacitor branch comprises a second reference capacitor $C_{REF2}$ and a second reference switch $S_{REF2}$ connected to the second reference capacitor $C_{REF2}$.

Further, the first PTAT diode branch comprises the second diode D2 and a third PTAT circuit switch $S_{PTAT3}$ connected to the second diode D2.

Further, the second PTAT diode branch comprises a fourth PTAT circuit switch $S_{PTAT4}$ and a PTAT diode combination connected to the fourth PTAT circuit switch $S_{PTAT4}$, and the PTAT diode combination comprises a plurality of third diodes D3 connected in parallel.

Further, when the digital output signal is a 1-bit digital output, both the first PTAT capacitor branch and the second PTAT capacitor branch comprise a first reference capacitor $C_{REF1}$.

Further, when the digital output signal is an $N$-bit output, and $N$ is greater than 1, both the first PTAT capacitor branch and the second PTAT capacitor branch comprise $N$ parallel first capacitor branches, the first capacitor branch comprises a first reference capacitor $C_{REF1}$ and a first reference switch $S_{REF1}$ connected to the first reference capacitor $C_{REF1}$.

Further, the second reference capacitor $C_{REF2}$ is pre-charged to a power supply voltage $V_{DD}$ through the first CTAT circuit switch $S_{CAT1}$, then the first CTAT circuit switch $S_{CAT1}$ is switched off, the second CTAT circuit switch $S_{CTAT2}$ is switched on, and the second reference capacitor $C_{REF2}$ is discharged through the first diode D1; and when a residual voltage on the second reference capacitor $C_{REF2}$ decreases with the increase of temperature in a fixed discharge duration, the residual voltage is the CTAT voltage $V_D$.

Further, a first reference capacitor $C_{REF1}$ of the first capacitively-biased diode circuit is pre-charged to the power supply voltage $V_{DD}$ through the first PTAT circuit switch $S_{PTAT1}$, then the first PTAT circuit switch $S_{PTAT1}$ is switched off and the third PTAT circuit switch $S_{PTAT3}$ is switched on, and the first reference capacitor $C_{REF1}$ of the first capacitively-biased diode circuit is discharged through the second diode D2 to obtain a first residual voltage $V_{D1}$.

Further, a first reference capacitor $C_{REF1}$ of the second capacitively-biased diode circuit is pre-charged to the power supply voltage $V_{DD}$ through the second PTAT circuit switch $S_{PTAT2}$, then the second PTAT circuit switch $S_{PTAT2}$ is switched off, the fourth PTAT circuit switch $S_{PTAT4}$ is switched on, and the first reference capacitor $C_{REF1}$ of the second capacitively-biased diode circuit is discharged through the PTAT diode combination to obtain a second residual voltage $V_{D2}$.

Further, a voltage difference $V_{D1}-V_{D2}$ between the first residual voltage $V_{D1}$ and the second residual voltage $V_{D2}$ increases with the increase of temperature, and the voltage difference is the PTAT voltage $\Delta V_D$.

Further, the first CTAT circuit switch $S_{CTAT1}$, control timing sequences of the first PTAT circuit switch $S_{PTAT1}$ and the second PTAT circuit switch $S_{PTAT2}$ are the same.

Further, control timing sequences of the second CTAT circuit switch $S_{CTAT2}$, the third PTAT circuit switch $S_{PTAT3}$ and the fourth PTAT circuit switch $S_{PTAT4}$ are the same, and a ratio of an area of the second diode D2 to an area of the PTAT diode combination is set as 1: $p$, and $p$ is greater than 1.

Further, control timing sequences of the second CTAT circuit switch $S_{CTAT2}$ and the third PTAT circuit switch $S_{PTAT3}$ are the same, an area of the second diode D2 is equal to an area of the PTAT diode combination, starting times of switching on the third PTAT circuit switch $S_{PTAT3}$ and the fourth PTAT circuit switch $S_{PTAT4}$ are the same, a ratio of durations switching on is 1: $p$, and $p$ is greater than 1.

Further, the analog to digital converter is a Delta-Sigma analog to digital converter, the Delta-Sigma analog to digital converter comprises a Delta-Sigma modulator, the Delta-Sigma modulator comprises the capacitive digital to analog converter and a first-order integrator, the capacitive digital to analog converter generates the CTAT voltage $V_D$ and the PTAT voltage $\Delta V_D$, the CTAT voltage $V_D$ and the PTAT voltage $\Delta V_D$ are added and combined by the first-order integrator to obtain a reference signal reference $V_{REF}=\alpha\Delta V_D+V_D$, wherein $\alpha=C_{REF1}/C_{REF2}$.

Further, the first-order integrator comprises an integrating capacitor $C_{INT}$, and a control timing sequence of the Delta-Sigma modulator comprises: realizing signal sampling of an input signal $V_{IN}$ in a sampling period $\Phi1$ and realizing signal transferring and integrating in an integrating period $\Phi2$; wherein, for a reference signal branch, the sampling period $\Phi1$ is divided into two parts: rst and $\Phi3$, wherein in the rst state, the first reference capacitor $C_{REF1}$ and the second reference capacitor $C_{REF2}$ are pre-charged to the power supply voltage; in the $\Phi3$ state, the second reference capacitor $C_{REF2}$ is discharged through the first diode D1, the first reference capacitor $C_{REF1}$ is discharged through the second diode D2 and the PTAT diode combination, and the reference signal is sampled at the first reference capacitor $C_{REF1}$ and the second reference capacitor $C_{REF2}$ at the end of $\varphi3$ and $\varphi1$; and in an integrating phase $\Phi2$, charges on the first reference capacitor $C_{REF1}$ and the second reference capacitor $C_{REF2}$ are transferred to the integrating capacitor $C_{INT}$.

Further, when the Delta-Sigma modulator outputs a 1-bit BS code stream, $+/-V_{REF}$ is generated according to the output 1-bit BS code stream, which is used for balancing with the input signal $V_{IN}$, and an average value of the BS code stream is $V_{1N}/V_{REF}$.

Further, the analog to digital converter is a charge-sharing successive approximation register analog to digital converter, the successive approximation register analog to digital converter comprises an input capacitor CIN, the capacitive digital to analog converter and a comparator, and the capacitive digital to analog converter samples the reference signal independent of temperature on the N-bit first reference capacitor $C_{REF1}$ and the second reference capacitor $C_{REF2}$ in a sampling stage, and generates a feedback control signal in equal proportion to the reference signal according to comparator results in a comparison stage.

Further, in the capacitive digital to analog converter, one end of the first CTAT circuit switch $S_{CTAT1}$ of the CTAT circuit based on the capacitively-biased diode is also connected to a sixth CTAT circuit switch $S_{CTAT6}$, and when the digital output signal is an N-bit digital output, and N is greater than 1, the CTAT capacitor branch comprises N parallel second capacitor branches, the second capacitor branch comprises the second reference capacitor $C_{REF2}$, and the second reference switch $S_{REF2}$ connected to the second reference capacitor $C_{REF2}$, and further comprises a fourth reference switch $S_{REF4}$ connected to the second reference capacitor $C_{REF2}$, and the fourth reference switch $S_{REF4}$ is connected to an MSB or an LSB; and

in the PTAT circuit based on the capacitively-biased diode, one end of the first PTAT circuit switch $S_{PTAT1}$ is also connected to a seventh PTAT circuit switch $S_{PTAT7}$, one end of the second PTAT circuit switch $S_{PTAT2}$ is connected to the seventh PTAT circuit switch $S_{PTAT7}$, the first PTAT capacitor branch and the second PTAT capacitor branch both comprise N parallel first capacitor branches, the first capacitor branch comprises the first reference capacitor $C_{REF1}$, and the first reference switch $S_{REF1}$ connected to the first reference capacitor $C_{REF1}$, and further comprises a third reference switch $S_{REF3}$ connected to the first reference capacitor $C_{REF1}$, and the third reference switch $S_{REF3}$ is connected to the MSB or the LSB; the second PTAT capacitor branch further comprises an eighth PTAT circuit switch $S_{PTAT8}$, one end of the eighth PTAT circuit switch $S_{PTAT8}$ is connected to the N parallel first capacitor branches, and the other end of the eighth PTAT circuit switch $S_{PTAT8}$ is grounded; and one end of the eighth PTAT circuit switch $S_{PTAT8}$ is also connected to the sixth CTAT circuit switch $S_{CTAT6}$.

Further, a control timing sequence of the charge-sharing successive approximation register analog to digital converter comprises: sampling and holding an input signal on an input capacitor CIN, and holding a reference voltage of the reference signal on the first reference capacitor $C_{REF1}$ and the second reference capacitor $C_{REF2}$; differencing input signals INP and INN to realize signal sampling held on the input capacitor CIN when a sampling phase Fs is high, and for the reference signal branch, accessing the first reference capacitor $C_{REF1}$ to the circuit at the sampling phase Fs through first reference switch $S_{REF1}$ and third reference switch $S_{REF3}$, and accessing the second reference capacitor $C_{REF2}$ to the circuit at the sampling phase Fs through the second reference switch $S_{REF2}$ and fourth reference switch $S_{REF4}$ into the circuit to generate the reference signal; wherein the sampling phase Fs is detachable into two parts: a $\Phi1$ phase and a $\Phi2$ phase, the

$\Phi1$ phase realizes generation of a PTAT voltage signal $\Delta V_D$ which is positively related to temperature and a CTAT voltage signal $V_D$ which is negatively related to temperature; and the $\varphi2$ phase realizes proportional addition of the PTAT voltage signal $\Delta V_D$ and the CTAT voltage signal $V_D$ to obtain a reference signal $\alpha\Delta V_D+V_D$ which is independent of temperature; wherein, for the generation of the PTAT voltage signal $\Delta V_D$ and the CTAT voltage signal $V_D$, the $\Phi1$ phase is further divided into two sub-phases: rst and $\Phi d/\Phi d1,2$; in the rst state, the first reference capacitor $C_{REF1}$ and the second reference capacitor $C_{REF2}$ are pre-charged to the power supply voltage $V_{DD}$; in the $\Phi d$ state, the second reference capacitor $C_{REF2}$ is discharge through the first diode D1, in the $\Phi d1$ and $\Phi d2$ states, the first reference capacitor $C_{REF1}$ is discharged through the second diode D2 and a combination of the third diodes D3, and at the end of $\Phi1$, $\Phi d$ and $\Phi d1,2$, the PTAT voltage signal $\Delta V_D$ and the CTAT voltage signal $V_D$ are respectively sampled at the first reference capacitor $C_{REF1}$ and the second reference capacitor $C_{REF2}$; and at the $\Phi2$ phase, the eighth PTAT circuit switch $S_{PTAT8}$ is switched off, while the sixth CTAT circuit switch $S_{PTAT6}$ and the seventh PTAT circuit switch $S_{PTAT7}$ are switched on, so that the PTAT voltage signal $\Delta V_D$ and the CTAT voltage signal $V_D$ are added, and the reference signal independent of temperature is generated at the first reference capacitor $C_{REF1}$ and the second reference capacitor $C_{REF2}$; and

after the sampling phase Fs ends, entering a comparative quantization phase $\Phi_{SAR}$, and sharing charges among the first reference capacitor $C_{REF1}$, the second reference capacitor $C_{REF2}$ and the input capacitor CIN through an algorithm logic of successive approximation to obtain a comparator input voltage, and comparing, by the comparator, results obtained to control next working state of the capacitive digital to analog converter; and performing multiple successive approximation comparison to obtain the finally converted output signal.

Further, the analog to digital converter is a pipelined analog to digital converter, and the pipelined analog to digital converter comprises conversion modules cascaded in series stage by stage, wherein the conversion module in each stage comprises the sample-and-hold circuit and the capacitive digital-to-analog converter, and the sample-and-hold circuit samples and holds an analog input signal to obtain a first signal; the conversion module in each step comprises the sample-hold circuit and the capacitive digital to analog converter, and the sample-hold circuit performs sampling and holding on the analog input signal to obtain the first signal; the capacitive digital to analog converter generates the reference signal and generates the second signal in equal proportion to the reference signal according to the feedback digital output signal, and the first signal and the second signal are differenced to obtain the error signal.

A second aspect discloses a calibration method for an analog to digital converter integrated with reference voltage generation applied to the analog to digital converter integrated with reference voltage generation above, comprising:

step 1: inputting an analog input signal to the analog to digital converter integrated with reference voltage generation to obtain a digital output signal;

step 2: differencing the digital output signal and an ideal value to obtain a difference value; and

step 3: adjusting a reference capacitor or a discharge duration of the capacitive digital to analog converter according to the difference value, thereby calibrating the digital output signal.

Further, the ideal value in the step 2 is a ratio of an analog input signal value to a reference signal value expected to be designed.

Further, the step 3 comprises:

when the difference value is positive, increasing a first reference capacitor $C_{REF1}$ or a second reference capacitor $C_{REF2}$ until the difference value is zero; and

when the difference value is negative, decreasing the first reference capacitor $C_{REF1}$ or the second reference capacitor $C_{REF2}$ until the difference value is zero.

Further, the step 3 comprises:

when the difference value is positive, decreasing a discharge duration of the first reference capacitor $C_{REF1}$ or the second reference capacitor $C_{REF2}$ until the difference value is zero; and

when the difference value is positive, increasing the discharge duration of the first reference capacitor $C_{REF1}$ or the second reference capacitor $C_{REF2}$ until the difference value is zero.

Beneficial effects:

The analog to digital converter provided by the present application is internally provided with the high-precision reference source, that is, the reference signal is directly sampled in the capacitive digital to analog converter of the analog to digital converter, without needing an additional reference signal generating circuit and an additional reference signal driver, thus solving defects of large power consumption, area and error and the like of a conventional architecture. The analog to digital converter may be used in various switched capacitor ADCs, such as Delta-Sigma ADC, SAR ADC and Pipelined ADC.

Aiming at the analog to digital converter provided, the calibration method of the analog to digital converter integrated with reference voltage generation is also provided, which only needs one-step calibration, i.e., giving the input voltage, measuring an output of the analog to digital converter, and calibrating the capacitive digital to analog converter of the analog to digital converter according to the output to realize output calibration without needing to calibrate a reference circuit individually in the conventional architecture, thus reducing system calibration cost and achieving high precision.

## BRIEF DESCRIPTION OF THE DRAWINGS

The advantages of the above and/or other aspects of the present invention will become more apparent by further explaining the present invention with reference to the following drawings and detailed description.

FIG. 1 is a schematic architecture diagram of a conventional ADC.

FIG. 2 is a schematic architecture diagram of an analog to digital converter provided by the embodiments of the present application.

FIG. 3 is a schematic diagram showing a circuit structure and a working principle of a CBD.

FIG. 4 is a schematic diagram showing a circuit structure of the CBD for generating PTAT and CTAT voltages.

FIG. 5 is a schematic architecture diagram of a CDAC based on a CBD principle in the analog to digital converter provided by the embodiments of the present application.

FIG. 6 is a schematic circuit diagram of a Delta-Sigma modulator with an integrated reference voltage generating circuit provided by the embodiments of the present application.

FIG.7 is a schematic circuit diagram of a charge-sharing SAR ADC with an integrated reference voltage generating circuit provided by the embodiments of the present application.

FIG. 8 is a schematic circuit diagram of a Pipelined ADC comprising a CBD CDAC provided by the embodiments of the present application.

## DETAILED DESCRIPTION

In the following, the technical solutions in the embodiments of the present invention will be clearly and completely described with reference to the drawings in the embodiments of the present invention, and the described embodiments are only possible technical implementations of the present invention, rather than all possible implementations. Those skilled in the art can completely combine the embodiments of the present invention to obtain other embodiments without creative work, and these embodiments are also within the protection scope of the present invention.

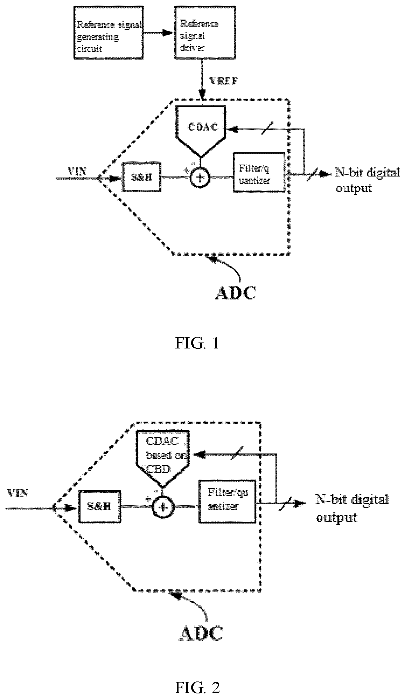

FIG. 1 is a conventional switched capacitor analog to digital converter architecture and peripheral modules thereof, which mainly comprises an analog to digital converter ADC, an additional reference signal generating circuit and a reference signal driver. An input signal VIN passes through a sample-and-hold circuit S&H, and is differenced with a feedback reference signal to obtain an error signal, and then passes through a loop filter and quantizer to obtain a digital output. The digital output is also used for feedback control of a Digital to Analog Converter (DAC), and together with an external input reference signal $V_{REF}$ to generate a feedback reference signal.

The inventor of the present invention found that in the conventional architecture, the ADC, the reference signal generating circuit and the reference signal driver need to be designed separately. Even if each module is well optimized, it is often impossible to achieve overall signal optimization of the system when the modules are combined. Especially, in order to drive the ADC, the reference signal driver needs large power consumption and area, which may also introduce additional errors, such as DC offset, noise and so on. In a system application, in order to achieve high precision, each module needs to be calibrated separately, and calibration methods are different, which further increases system cost. For example, to calibrate the reference signal, an extra pin is needed, and a reference signal output is measured by a high-precision multi-meter and calibrated. In order to calibrate the ADC, it is necessary to give another signal source input VIN to calibrate an error of the ADC. Based on this, in one embodiment of the present application provided by the inventor, the capacitive digital to analog converter (CDAC) of the analog to digital converter integrated with reference voltage generation is directly provided with a reference signal generation function, which eliminates the need for the additional reference signal generating circuit and a reference signal driving circuit. Compared with the traditional architecture, the area and the power consumption of the analog to digital converter integrated with reference voltage generation are greatly reduced, and possible error sources are reduced as the additional reference signal generating circuit and the additional reference signal driver are not needed. In addition, in order to further improve the precision, the calibration of the architecture of the analog to digital converter provided by the embodiments of the present application only needs one calibration, that is, the signal all-path integral calibration can be realized by giving the input signal VIN, and directly measuring the ADC output.

As shown in FIG. 2, in one embodiment of the present application, the analog to digital converter integrated with reference voltage generation comprises a sample-hold circuit S&H, a capacitive digital to analog converter CDAC and a quantizer, wherein the sample-hold circuit S&H is configured for sampling and holding an analog input signal VIN to obtain a first signal; the capacitive digital to analog converter CDAC is configured for generating a reference signal and generating a second signal in equal proportion to the reference signal according to a feedback digital output signal, for example, the second signal is a product of the reference signal and the feedback digital output signal; and differencing the first signal and the second signal to obtain an error signal; and the quantizer is configured for digitizing the error signal to obtain a digital output signal. The digital output signal supports $N$-bit output, wherein $N$ is greater than or equal to 1. Optionally, in some analog to digital converters, for example, in a Delta-Sigma analog to digital converter, a loop filter may be added in front of the quantizer, and the loop filter is configured for noise shaping to improve a resolution.

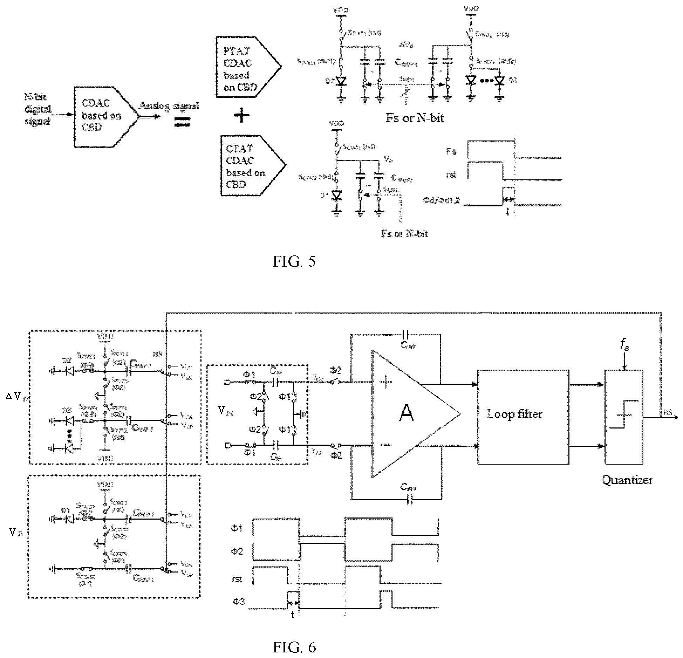

As shown in FIG. 5, in the embodiments of the present application, the capacitive digital to analog converter comprises a CTAT (complementary to absolute temperature) circuit based on a capacitively-biased diode and a PTAT (proportional to absolute temperature) circuit based on a capacitively-biased diode, the CTAT circuit based on the capacitively-biased diode and the PTAT circuit based on the capacitively-biased diode jointly generate the reference signal, and the reference signal is independent of temperature.

The CTAT circuit based on the capacitively-biased diode generates a CTAT voltage $V_D$ which decreases with the increase of temperature, and the PTAT circuit based on the capacitively-biased diode generates a PTAT voltage $\Delta V_D$ which increases with the increase of temperature, the CTAT voltage $V_D$ and the PTAT voltage $\Delta V_D$ are combined and added to generate a reference voltage $V_{REF}$ of the reference signal, $V_{REF} = \alpha \Delta V_D + V_D$, $\alpha$ is a scale factor, and a value of the scale factor $\alpha$ makes the reference voltage $V_{REF}$ independent of temperature.

In the embodiments of the present application, the CTAT circuit based on the capacitively-biased diode comprises a first CTAT circuit switch $S_{CTAT1}$, a CTAT diode branch and a CTAT capacitor branch, one end of the first CTAT circuit switch $S_{CTAT1}$ is connected to one end of the CTAT diode branch and one end of the CTAT capacitor branch respectively, and the other end of the CTAT diode branch and the other end of the CTAT capacitor branch are both grounded; and the other end of the first CTAT circuit switch $S_{CTAT1}$ is connected to a power supply. In order to pre-charge the CTAT capacitor branch to the power supply, the first CTAT circuit switch $S_{CTAT1}$ may be realized by using a common PMOS switch.

In one embodiment of the present application, the CTAT diode branch comprises a first diode D1 and a second CTAT circuit switch $S_{CTAT2}$ connected to the first diode D1. The first diode D1 may be a P+/Nwell diode or a Pwell/N+ diode. In order to reduce influences of switch on resistance and charge feedthrough on the CTAT voltage, the second CTAT circuit switch $S_{CTAT2}$ may be a bootstrap switch with grid voltage or a switch with dummy transistor.

In other embodiments of the present application, the first diode D1 in the CTAT diode branch may be replaced by a diode-connected triode (shorting a base and a collector of the BJT) or a DTMOST (dynamic threshold MOS transistor) and other devices. The BJT may be a PNP or an NPN, a base and a collector are shorted to form an equivalent diode, so that better diode performances are realized.

In various embodiments of the present application, when the digital output signal is a 1-bit digital output, the CTAT capacitor branch comprises one second reference capacitor $C_{REF2}$. The second reference capacitor $C_{REF2}$ may be an MIM (Metal-Insulator-Metal) capacitor or an MOM (Metal-Oxide-Metal) capacitor.

When the digital output signal is an *N*-bit output, and *N* is greater than 1, the CTAT capacitor branch comprises *N* parallel second capacitor branches, and the second capacitor branch comprises one second reference capacitor $C_{REF2}$ and one second reference switch $S_{REF2}$ connected to the second reference capacitor $C_{REF2}$, that is, the second reference capacitor $C_{REF2}$ may be split into N-bits for digital control as required to form an N-bit capacitive digital to analog converter. The second reference capacitor $C_{REF2}$ may be an MIM capacitor or an MOM capacitor. The second reference switch $S_{REF2}$ may be an ordinary NMOS switch.

In the embodiments of the present application, the PTAT circuit based on the capacitively-biased diode comprises the first capacitively-biased diode circuit and a second capacitively-biased diode circuit, and a voltage difference generated by the two circuits is the PTAT voltage $\Delta_{VD}$.

The first capacitively-biased diode circuit comprises a first PTAT circuit switch $S_{PTAT1}$, a first PTAT diode branch and a first PTAT capacitor branch, one end of the first PTAT circuit switch $S_{PTAT1}$ is connected to one end of the first PTAT diode branch and one end of the first PTAT capacitor branch respectively, and the other end of the first PTAT diode branch and the other end of the first PTAT capacitor branch are both grounded; and the other end of the first CTAT circuit switch $S_{CTAT1}$ is connected to a power supply. In order to pre-charge the first PTAT capacitor branch to the power supply, the first CTAT circuit switch $S_{CTAT1}$ may be realized by using a common PMOS switch.

The second capacitively-biased diode circuit comprises a second PTAT circuit switch $S_{PTAT2}$, a second PTAT diode branch and a second PTAT capacitor branch, one end of the second PTAT circuit switch $S_{PTAT2}$ is connected to one end of the second PTAT diode branch and one end of the second PTAT capacitor branch respectively, and the other end of the second PTAT diode branch and the other end of the second PTAT capacitor branch are both grounded; and the other end of the second PTAT circuit switch $S_{PTAT2}$ is connected to the power supply. In order to pre-charge the second PTAT capacitor branch to the power supply, the second PTAT circuit switch $S_{PTAT2}$ may be realized by using a common PMOS switch.

In one embodiment of the present application, the CTAT diode branch comprises a second diode D2 and a third PTAT circuit switch $S_{PTAT3}$ connected to the connected to the second diode D2. The second diode D2 may be a P+/Nwell diode or a Pwell/N+ diode. In order to reduce influences of switch on resistance and charge feedthrough on the PTAT voltage, the third PTAT circuit switch $S_{PTAT3}$ may be a bootstrap switch with grid voltage or a switch with dummy transistor.

The second PTAT diode branch comprises a fourth PTAT circuit switch $S_{PTAT4}$ and the PTAT diode combination connected to the fourth PTAT circuit switch $S_{PTAT4}$, and the PTAT diode combination comprises a plurality of third diodes D3 connected in parallel. In order to reduce influences of switch on resistance and charge feedthrough on the PTAT voltage, the fourth PTAT circuit switch $S_{PTAT4}$ may be a bootstrap switch with grid voltage or a switch with dummy transistor, and the third diode D3 may be a P+/Nwell diode or a Pwell/N+ diode.

In other embodiments of the present application, both the second diode D2 in the first PTAT diode branch and the third diode D3 in the PTAT diode combination may be replaced by a diode-connected triode (shorting a base and a collector of the triode) or a DTMOST (dynamic threshold MOS transistor) and other devices. The triode may be a PNP or an NPN, a base and a collector are shorted to form an equivalent diode, so that better diode performances are realized.

In various embodiments of the present application, when the digital output signal is a 1-bit digital output, both the first PTAT capacitor branch and the second PTAT capacitor branch comprise one first reference capacitor $C_{REF1}$. The first reference capacitor $C_{REF1}$ may be an MIM capacitor or an MOM capacitor, and needs to be of the same type as the second reference capacitor $C_{REF2}$.

When the digital output signal is an *N*-bit output, and *N* is greater than 1, the first PTAT capacitor branch and the second PTAT capacitor branch both comprise *N* parallel first capacitor branches, and the first capacitor branch comprises one first reference capacitor $C_{REF1}$ and one first reference switch $S_{REF1}$ connected to the first reference capacitor $C_{REF1}$, that is, the first reference capacitor $C_{REF1}$ may be split into N-bits for digital control as required to form an N-bit capacitive digital to analog converter. The first reference capacitor $C_{REF1}$ may be an MIM capacitor or an MOM capacitor, and needs to be the same type as the second reference capacitor $C_{REF2}$. The first reference switch $S_{REF1}$ may be an ordinary NMOS switch.

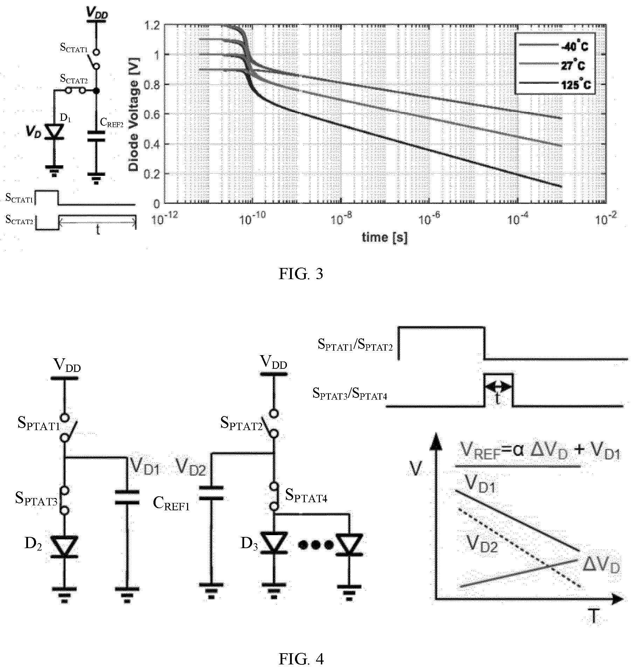

As shown in FIG. 3, in the embodiments of the present application, the second reference capacitor $C_{REF2}$ is pre-charged to a power supply voltage $V_{DD}$ through the first CTAT circuit switch $S_{CAT1}$, then the first CTAT circuit switch $S_{CAT1}$ is switched off, the second CTAT circuit switch $S_{CTAT2}$ is switched on, and the second reference capacitor $C_{REF2}$ is discharged through the first diode D1. A residual voltage on the capacitor decreases with time. After a period of time (nanosecond), the residual voltage on the capacitor has nothing to do with an initial voltage thereof, but is only determined by diode characteristics. When a residual voltage on the second reference capacitor $C_{REF2}$ decreases with the increase of temperature in a fixed discharge duration, the residual voltage is the CTAT voltage $V_D$, and an expression of $V_D$ is as follows:

$$V_D = V_T (V_T * C_{REF2}/t/I_S)$$

wherein, $V_T$ represents a thermal voltage, which may be expressed as $V_T = kT/q$, T represents a current temperature, k represents a Boltzmann constant, q represents a charge constant, t represents a duration to switch on the second CTAT circuit switch $S_{CTAT2}$, and Is represents a saturation current of the diode or the triode. As shown in FIG. 3, the diode voltage is also the CTAT voltage $V_D$, the CTAT voltage $V_D$ decreases with time, and meanwhile, the CTAT voltage $V_D$ decreases with the increase of temperature.

As shown in FIG. 4, a first reference capacitor $C_{REF1}$ of the first capacitively-biased diode circuit is pre-charged to the power supply voltage $V_{DD}$ through the first PTAT circuit switch $S_{PTAT1}$, then the first PTAT circuit switch $S_{PTAT1}$ is switched off and the third PTAT circuit switch $S_{PTAT3}$ is switched on, and the first reference capacitor $C_{REF1}$ of the first capacitively-biased diode circuit is discharged through the second diode D2 to obtain a first residual voltage $V_{D1}$.

A first reference capacitor $C_{REF1}$ of the second capacitively-biased diode circuit is pre-charged to the power supply voltage $V_{DD}$ through the second PTAT circuit switch $S_{PTAT2}$, then the second PTAT circuit switch $S_{PTAT2}$ is switched off, the fourth PTAT circuit switch $S_{PTAT4}$ is switched on, and the first reference capacitor $C_{REF1}$ of the second capacitively-biased diode circuit is discharged through the PTAT diode combination to obtain a second residual voltage $V_{D2}$.

a voltage difference $V_{D1} - V_{D2}$ between the first residual voltage $V_{D1}$ and the second residual voltage $V_{D2}$ increases with the increase of temperature, the voltage difference is the PTAT voltage $\delta V_D$, and an expression of $V_D$ is as follows:

$$\Delta V_D = V_{D1} - V_{D2} = kT/q \, (p)$$

wherein, p represents a ratio of an area of the second diode D2 to an area of the PTAT diode combination, or a ratio of durations switching on when starting times of switching on the third PTAT circuit switch $S_{PTAT3}$ and the fourth PTAT circuit switch $S_{PTAT4}$ are the same.

As shown in a graph of relationship between temperature and voltage with a temperature T as an abscissa and a voltage V as an ordinate on the right side of FIG. 4, if the PTAT voltage $\delta V_D$ and the CTAT voltage $V_D$ are combined and added in a certain proportion, temperature characteristics thereof can be offset, and a bandgap reference voltage output $V_{REF} = \alpha \Delta V_D + V_D$ independent of temperature can be realized. For example, by setting relative proportions of the first reference capacitor $C_{REF1}$ and the second reference capacitor $C_{REF2}$, proportions of the PTAT circuit and the CTAT circuit can be adjusted, so as to realize the temperature coefficient balance cancellation of the two in a charge domain and realize equivalent bandgap reference.

In the embodiments of the present application, control timing sequences of the first CTAT circuit switch $S_{CTAT1}$, the first PTAT circuit switch $S_{PTAT1}$ and the second PTAT circuit switch $S_{PTAT2}$ are the same.

In one embodiment of the present application, control timing sequences of the second CTAT circuit switch $S_{CTAT2}$, the third PTAT circuit switch $S_{PTAT3}$ and the fourth PTAT circuit switch $S_{PTAT4}$ are the same, and a ratio of an area of the second diode D2 to an area of the PTAT diode combination is set as 1: p, and p is greater than 1. The third diode D3 in the PTAT diode combination may be the same as the second diode D2, and the PTAT diode combination contains p third diodes D3, or the third diode D3 may be different from the second diode D2, as long as the ratio of the area of the second diode D2 to the area of PTAT diode combination is set to 1: p, which will not affect the implementation of the embodiments of the present application. Here, a proportional relationship of current density is formed by setting the ratio of the area of the second diode D2 to the area of the PTAT diode combination to 1: p, so that the PTAT voltage $\Delta_{VD}$ which increases with the increase of temperature is generated.

In another embodiment of the present invention, control timing sequences of the second CTAT circuit switch $S_{CTAT2}$ and the third PTAT circuit switch $S_{PTAT3}$ are the same, an area of the second diode D2 is equal to an area of the PTAT diode combination, starting times of switching on the third PTAT circuit switch $S_{PTAT3}$ and the fourth PTAT circuit switch $S_{PTAT4}$ are the same, a ratio of durations switching on is 1: p, and p is greater than 1. The PTAT diode combination may contain one third diode D3, the third diode D3 and the second diode D2 are the same, or the PTAT diode combination may contain a plurality of third diodes D3, as long as the area ratio of the second diode D2 to the area of the PTAT diode combination is equal, which will not affect the implementation of the embodiments of the present application. Here, by controlling durations of switching on of the third PTAT circuit switch $S_{PTAT3}$ and the fourth PTAT circuit switch $S_{PTAT4}$, i.e., through a discharge duration of the second diode D2 and the PTAT diode combination, a current density flowing through the second diode D2 and the PTAT diode combination is controlled, thereby generating the PTAT voltage $\Delta V_D$ which increases with the increase of temperature.

Based on the above architecture, the embodiments of the present application can be applied to the existing ADC architectures of various switched capacitors, thereby eliminating the additional reference signal generating circuit and additional reference signal driving circuit in the existing architectures and greatly simplifying the system architecture.

As shown in FIG. 6, the analog to digital converter may be a Delta-Sigma analog to digital converter, and the Delta-Sigma analog to digital converter comprises a Delta-Sigma modulator. The Delta-Sigma modulator comprises the capacitive digital to analog converter and a first-order integrator, and the capacitive digital to analog converter comprises a CTAT circuit based on a capacitively-biased diode and a PTAT circuit based on a capacitively-biased diode. The CTAT circuit based on the capacitively-biased diode generates the CTAT voltage $V_D$ which decreases with the increase of temperature. The PTAT circuit based on the capacitively-biased diode generates the PTAT voltage $\Delta V_D$ which increases with the increase of temperature. The CTAT voltage $V_D$ and the PTAT voltage $\Delta V_D$ are added and combined by the first-order integrator to obtain a reference signal reference $V_{REF}=\alpha\Delta V_D+V_D$, wherein $\alpha$ is a scale factor, and a value of the scale factor $\alpha$ makes the reference voltage $V_{REF}$ independent of temperature. A loop filter in FIG. 6 indicates that integrators of more orders can be cascaded later.

The CTAT circuit based on the capacitively-biased diode comprises a first CTAT circuit switch $S_{CTAT1}$, a CTAT diode branch and a CTAT capacitor branch. One end of the first CTAT circuit switch $S_{CTAT1}$ is connected to one end of the CTAT diode branch and one end of the CTAT capacitor branch respectively, one end of the first CTAT circuit switch SCTAT1 is also connected to a third CTAT circuit switch SCTAT3, the other end of the CTAT diode branch is grounded, the other end of the CTAT capacitor branch is connected to an input end of the first-order integrator, and the input end of the first-order integrator comprises a positive end $V_{GP}$ and a negative end $V_{GN}$. The other end of the first CTAT circuit switch $S_{CTAT1}$ is connected to a power supply. The CTAT diode branch comprises a first diode D1 and a second CTAT circuit switch $S_{CTAT2}$ connected to the first diode D1. When a 1-bit BS code stream is output, the CTAT capacitor branch comprises one second reference capacitor $C_{REF2}$. In a differential analog to digital converter, another group of capacitors is needed to form a fully differential structure, which is equivalent to sampling 0V (ground). In the specific implementation process, the CTAT circuit based on the capacitively-biased diode further comprises one branch consisting of the second reference capacitor $C_{REF2}$ and a fourth CTAT circuit switch $S_{CTAT4}$. One end of the second reference capacitor $C_{REF2}$ is connected to the input end of the first-order integrator, the other end of the second reference capacitor $C_{REF2}$ is connected to one end of the fourth CTAT circuit switch $S_{CTAT4}$, and the other end of the fourth CTAT circuit switch $S_{CTAT4}$ is grounded. The other end of the second reference capacitor $C_{REF2}$ and one end of the fourth CTAT circuit switch $S_{CTAT4}$ are also connected to a fifth CTAT circuit switch $S_{CTAT5}$, the fifth CTAT circuit switch $S_{CTAT5}$ and the third CTAT circuit switch $S_{CTAT3}$ are connected and are commonly connected to an AC ground. The AC ground is generally a common mode level. According to the fact whether the BS code stream is 0 or 1, the CTAT circuit based on a capacitively-biased diode selects whether to input $+V_{REF}$ or $-V_{REF}$, that is, whether to connect the positive end $V_{GP}$ or the negative end $V_{GN}$ of the first-order integrator.

The PTAT circuit based on the capacitively-biased diode comprises a first capacitively-biased diode circuit and a second capacitively-biased diode circuit. The first capacitively-biased diode circuit comprises a first PTAT circuit switch $S_{PTAT1}$, a first PTAT diode branch and a first PTAT capacitor branch. One end of the first PTAT circuit switch SPTAT1 is connected to one end of the first PTAT diode branch and one end of the first PTAT capacitor branch respectively. One end of the first PTAT circuit switch SPTAT1 is also connected to a fifth PTAT circuit switch $S_{PTAT5}$, the other end of the first PTAT diode branch is grounded, and the other end of the first PTAT capacitor branch is connected to the input end of the first-order integrator. The other end of the first CTAT circuit switch $S_{CTAT1}$ is connected to a power supply. The second capacitively-biased diode circuit comprises a second PTAT circuit switch $S_{PTAT2}$, a second PTAT diode branch and a second PTAT capacitor branch. One end of the second PTAT circuit switch $S_{PTAT2}$ is connected to one end of the second PTAT diode branch and one end of the second PTAT capacitor branch respectively, one end of the second PTAT circuit switch $S_{PTAT2}$ is also connected to a sixth PTAT circuit switch $S_{PTAT6}$, the other end of the second PTAT diode branch is grounded, and the other end of the second PTAT capacitor branch is connected to the input end of the first-order integrator. The other end of the second PTAT circuit switch $S_{PTAT2}$ is connected to the power supply. The fifth PTAT circuit switch $S_{PTAT5}$ and the sixth PTAT circuit switch $S_{PTAT6}$ are connected and are commonly connected to an AC ground. The AC ground is generally a common mode level.

The first PTAT diode branch comprises a second diode D2 and a third PTAT circuit switch $S_{PTAT3}$ connected to the connected to the second diode D2. The second PTAT diode branch comprises a fourth PTAT circuit switch $S_{PTAT4}$ and a PTAT diode combination connected to the fourth PTAT circuit switch $S_{PTAT4}$, and the PTAT diode combination comprises a plurality of third diodes D3 connected in parallel. When the digital output signal is a 1-bit digital output, both the first PTAT capacitor branch and the second PTAT capacitor branch comprise one first reference capacitor $C_{REF1}$.

In this embodiment, $\alpha$ is adjusted by a relative proportion of the first reference capacitor $C_{REF1}$ and the second reference capacitor $C_{REF2}$, and $\alpha=C_{REF1}/C_{REF2}$.

The first-order integrator comprises an integrating capacitor $C_{INT}$, and a control timing sequence of the Delta-Sigma modulator comprises: realizing signal sampling of an input signal $V_{IN}$ in a sampling period $\Phi1$ and realizing signal transferring and integrating in an integrating period $\Phi2$; wherein, for a reference signal branch, the sampling period $\Phi1$ is divided into two parts: rst and $\Phi3$, wherein in the rst state, the first reference capacitor $C_{REF1}$ and the second reference capacitor $C_{REF2}$ are pre-charged to the power supply voltage $V_{DD}$; in the $\Phi3$ state, the second reference capacitor $C_{REF2}$ is discharged through the first diode D1, the first reference capacitor $C_{REF1}$ is discharged through the second diode D2 and the PTAT diode combination, and the reference signal is sampled at the first reference capacitor $C_{REF1}$ and the second reference capacitor $C_{REF2}$ at the end of $\varphi3$ and $\varphi1$; and in an integrating phase $\Phi2$, charges on the first reference capacitor $C_{REF1}$ and the second reference capacitor $C_{REF2}$ are transferred to the integrating capacitor $C_{INT}$.

When the Delta-Sigma modulator outputs a 1-bit BS code stream, $+/-V_{REF}$ is generated according to the output 1-bit BS code stream, which is used for balancing with the input signal $V_{IN}$, and an average value of the BS code stream is $V_{IN}/V_{REF}$.

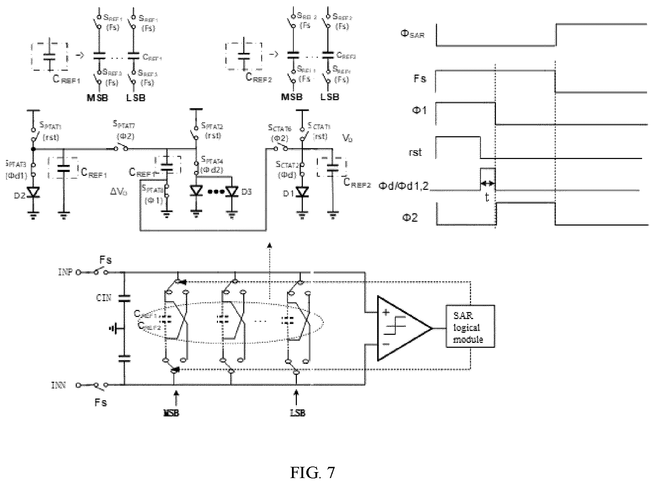

As shown in FIG.7, the analog to digital converter may also be a charge-sharing successive approximation register analog to digital converter (SAR ADC). The successive approximation register analog to digital converter comprises an input capacitor CIN, the capacitive digital to analog converter and a comparator. By using the above CBD principle, the capacitive digital to analog converter samples the reference signal independent of temperature on the N-bit first reference capacitor $C_{REF1}$ and the second reference capacitor $C_{REF2}$ in a sampling stage, and generates a feedback control signal in equal proportion to the reference signal according to comparator results in a comparison stage. A simplified equivalent diagram of the analog to digital converter is shown in a dashed box at the bottom of FIG. 7, and a specific implementation of the analog to digital converter is shown in a circuit diagram at the top of FIG. 7. The capacitive digital to analog converter comprises a CTAT circuit based on a capacitively-biased diode and a PTAT circuit based on a capacitively-biased diode. The CTAT circuit based on the capacitively-biased diode generates a CTAT voltage $V_D$ which decreases with the increase of temperature, and the PTAT circuit based on the capacitively-biased diode generates a PTAT voltage $\Delta V_D$ which increases with the increase of temperature. The CTAT voltage $V_D$ and the PTAT voltage $\Delta V_D$ are combined and added through a first-order integrator to generate a reference signal $V_{REF}=\alpha\Delta V_D+V_D$, wherein $\alpha$ is a scale factor, and a value of the scale factor $\alpha$ makes the reference voltage $V_{REF}$ independent of temperature.

The CTAT circuit based on the capacitively-biased diode comprises a first CTAT circuit switch $S_{CTAT1}$, a CTAT diode branch and a CTAT capacitor branch. One end of the first CTAT circuit switch $S_{CTAT1}$ is connected to one end of the CTAT diode branch and one end of the CTAT capacitor branch respectively. One end of the first CTAT circuit switch $S_{CTAT1}$ is also connected to a sixth CTAT circuit switch $S_{CTAT6}$, and the other end of the CTAT diode branch and the other end of the CTAT capacitor branch are both grounded. The other end of the first CTAT circuit switch $S_{CTAT1}$ is connected to a power supply. The CTAT diode branch comprises a first diode D1 and a second CTAT circuit switch $S_{CTAT2}$ connected to the first diode D1. When the digital output signal is an N-bit output, and N is greater than 1, the CTAT capacitor branch comprises N parallel second capacitor branches, and the second capacitor branch comprises a second reference capacitor $C_{REF2}$ and a second reference switch $S_{REF2}$ connected to the second reference capacitor $C_{REF2}$, and further comprises a fourth reference switch $S_{REF4}$ connected to the second reference capacitor $C_{REF2}$. The fourth reference switch $S_{REF4}$ is connected to an MSB or an LSB.

The PTAT circuit based on the capacitively-biased diode comprises a first capacitively-biased diode circuit and a second capacitively-biased diode circuit. The first capacitively-biased diode circuit comprises a first PTAT circuit switch $S_{PTAT1}$, a first PTAT diode branch and a first PTAT capacitor branch. One end of the first PTAT circuit switch $S_{PTAT1}$ is connected to one end of the first PTAT diode branch and one end of the first PTAT capacitor branch respectively. One end of the first PTAT circuit switch $S_{PTAT1}$ is also connected to a seventh PTAT circuit switch $S_{PTAT7}$, and the other end of the first PTAT capacitor branch and the other end of the first PTAT capacitor branch are both grounded. The other end of the first CTAT circuit switch $S_{CTAT1}$ is connected to a power supply. The second capacitively-biased diode circuit comprises a second PTAT circuit switch $S_{PTAT2}$, a second PTAT diode branch and a second PTAT capacitor branch. One end of the second PTAT circuit switch $S_{PTAT2}$ is connected to one end of the second PTAT diode branch and one end of the second PTAT capacitor branch respectively, one end of the second PTAT circuit switch $S_{PTAT2}$ is connected to the seventh PTAT circuit switch $S_{PTAT7}$, and the other end of the second PTAT diode branch and the other end of the second PTAT capacitor branch are both grounded. The other end of the second PTAT circuit switch $S_{PTAT2}$ is connected to the power supply.

The first PTAT diode branch comprises a second diode D2 and a third PTAT circuit switch $S_{PTAT3}$ connected to the connected to the second diode D2. The second PTAT diode branch comprises a fourth PTAT circuit switch $S_{PTAT4}$ and a PTAT diode combination connected to the fourth PTAT circuit switch $S_{PTAT4}$, and the PTAT diode combination comprises a plurality of third diodes D3 connected in parallel. When the digital output signal is an N-bit output, and N is greater than 1, the first PTAT capacitor branch and the second PTAT capacitor branch both comprise N parallel first capacitor branches, and the first capacitor branch comprises one first reference capacitor $C_{REF1}$ and one first reference switch $S_{REF1}$ connected to the first reference capacitor $C_{REF1}$, and further comprises a third reference switch $S_{REF3}$ connected to the first reference capacitor $C_{REF1}$. The third reference switch $S_{REF3}$ is connected to an MSB or an LSB. The second PTAT capacitor branch further comprises an eighth PTAT circuit switch $S_{PTAT8}$, one end of the eighth PTAT circuit switch $S_{PTAT8}$ is connected to the N parallel first capacitor branches, and the other end of the eighth PTAT circuit switch $S_{PTAT8}$ is grounded; and one end of the eighth PTAT circuit switch $S_{PTAT8}$ is also connected to the sixth CTAT circuit switch $S_{CTAT6}$. The sixth CTAT circuit switch $S_{CTAT6}$, the seventh PTAT circuit switch $S_{PTAT7}$ and the eighth PTAT circuit switch $S_{PTAT8}$ are used to add the CTAT voltage $V_D$ and the PTAT voltage $\Delta V_D$.

In this embodiment, $\alpha$ is adjusted by a relative proportion of the first reference capacitor $C_{REF1}$ and the second reference capacitor $C_{REF2}$, and $\alpha = C_{REF1}/C_{REF2}$.

A control timing sequence of the charge-sharing successive approximation register analog to digital converter comprises:

sampling and holding an input signal on an input capacitor CIN, and holding a reference voltage of the reference signal on the first reference capacitor $C_{REF1}$ and the second reference capacitor $C_{REF2}$; differencing input signals INP and INN to realize signal sampling held on the input capacitor CIN when a sampling phase Fs is high, and for the reference signal branch, accessing the first reference capacitor $C_{REF1}$ to the circuit at the sampling phase Fs through first reference switch $S_{REF1}$ and third reference switch $S_{REF3}$, and accessing the second reference capacitor $C_{REF2}$ to the circuit at the sampling phase Fs through the second reference switch $S_{REF2}$ and fourth reference switch $S_{REF4}$ into the circuit to generate the reference signal; wherein the sampling phase Fs is detachable into two parts: a $\Phi 1$ phase and a $\Phi 2$ phase, the $\Phi 1$ phase realizes generation of a PTAT voltage signal $\Delta V_D$ which is positively related to temperature and a CTAT voltage signal $V_D$ which is negatively related to temperature; and the $\varphi 2$ phase realizes proportional addition of the PTAT voltage signal $\Delta V_D$ and the CTAT voltage signal $V_D$ to obtain a reference signal $\alpha \Delta V_D + V_D$ which is independent of temperature; wherein, for the generation of the PTAT voltage signal $\Delta V_D$ and the CTAT voltage signal $V_D$, the $\Phi 1$ phase is further divided into two sub-phases: rst and $\Phi d/\Phi d1,2$; in the rst state, the first reference capacitor $C_{REF1}$ and the second reference capacitor $C_{REF2}$ are pre-charged to the power supply voltage $V_{DD}$; in the $\Phi d$ state, the second reference capacitor $C_{REF2}$ is discharge through the first diode D1, in the $\Phi d1$ and $\Phi d2$ states, the first reference capacitor $C_{REF1}$ is discharged through the second diode D2 and a combination of the third diodes D3, and at the end of $\Phi 1$, $\Phi d$ and $\Phi d1,2$, the PTAT voltage signal $\Delta V_D$ and the CTAT voltage signal $V_D$ are respectively sampled at the first reference capacitor $C_{REF1}$ and the second reference capacitor $C_{REF2}$; and at the $\Phi 2$ phase, the eighth PTAT circuit switch $S_{PTAT8}$ is switched off, while the sixth CTAT circuit switch $S_{CTAT6}$ and the seventh PTAT circuit switch $S_{PTAT7}$ are switched on, so that the PTAT voltage signal $\Delta V_D$ and the CTAT voltage signal $V_D$ are added, and the reference signal independent of temperature is generated at the first reference capacitor $C_{REF1}$ and the second reference capacitor $C_{REF2}$.

After the sampling phase Fs ends, entering a comparative quantization phase $\Phi_{SAR}$, and sharing charges among the first reference capacitor $C_{REF1}$, the second reference capacitor $C_{REF2}$ and the input capacitor CIN through an algorithm logic of successive approximation to obtain a comparator input voltage, and comparing, by the comparator, results obtained to control next working state of the capacitive digital to analog converter; and performing multiple successive approximation comparison to obtain the finally converted output signal.

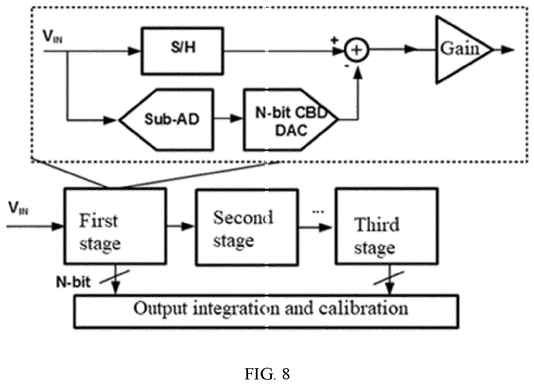

As shown in FIG. 8, the analog to digital converter may also be a pipelined analog to digital converter (pipelined ADC), and the pipelined analog to digital converter comprises conversion modules cascaded in series stage by stage, wherein the conversion module in each stage comprises the sample-and-hold circuit and the capacitive digital-to-analog converter, and the sample-and-hold circuit samples and holds an analog input signal to obtain a first signal; the capacitive digital to analog converter generates the reference signal and generates the second signal in equal proportion to the reference signal according to the feedback digital output signal, and the first signal and the second signal are differed to obtain the error signal. As shown in FIG. 8, the pipelined ADC has R orders, and each order realizes N-bit conversion. For the implementation of each stage, firstly, an input of a previous stage is sampled (S/H), and at the same time, quantization is realized through a sub-N-bit ADC. The quantized digital signal is converted into an analog signal through an N-bit sub-CDAC, is differentiated with the input signal, and then sent to next stage after amplification. The sub-CDAC may be realized by adopting the CDAC architecture based on the CBD principle in FIG. 5. In the specific implementation process, the N-bit sub-CDAC comprises a CTAT circuit based on a capacitively-biased diode and a PTAT circuit based on a capacitively-biased diode. The CTAT circuit based on the capacitively-biased diode and the PTAT circuit based on the capacitively-biased diode together generate the reference signal, and the reference signal is independent of temperature. The CTAT circuit based on the capacitively-biased diode generates a CTAT voltage $V_D$ which decreases with the increase of temperature, and the PTAT circuit based on the capacitively-biased diode generates a PTAT voltage $\Delta V_D$ which increases with the increase of temperature, the CTAT voltage $V_D$ and the PTAT voltage $\Delta V_D$ are combined and added to generate a reference voltage $V_{REF}$ of the reference signal, $V_{REF} = \alpha \Delta V_D + V_D$, $\alpha$ is a scale factor, and a value of the scale factor $\alpha$ makes the reference voltage $V_{REF}$ independent of temperature.

The CTAT circuit based on the capacitively-biased diode comprises a first CTAT circuit switch $S_{CTAT1}$, a CTAT diode branch and a CTAT capacitor branch, one end of the first CTAT circuit switch $S_{CTAT1}$ is connected to one end of the CTAT diode branch and one end of the CTAT capacitor branch respectively, and the other end of the CTAT diode branch and the other end of the CTAT capacitor branch are both grounded; and the other end of the first CTAT circuit switch $S_{CTAT1}$ is connected to a power supply. The CTAT diode branch comprises a first diode D1 and a second CTAT circuit switch $S_{CTAT2}$ connected to the first diode D1. When the digital output signal is an $N$-bit output, and $N$ is greater than 1, the CTAT capacitor branch comprises $N$ parallel second capacitor branches, the second capacitor branch comprises a second reference capacitor $C_{REF2}$ and a second reference switch $S_{REF2}$ connected to the second reference capacitor $C_{REF2}$.

The PTAT circuit based on the capacitively-biased diode comprises a first capacitively-biased diode circuit and a second capacitively-biased diode circuit. The first capacitively-biased diode circuit comprises a first PTAT circuit switch $S_{PTAT1}$, a first PTAT diode branch and a first PTAT capacitor branch. One end of the first PTAT circuit switch $S_{PTAT1}$ is connected to one end of the first PTAT diode branch and one end of the first PTAT capacitor branch respectively, and the other end of the first PTAT diode branch and the other end of the first PTAT capacitor branch are both grounded; and the other end of the first CTAT circuit switch $S_{CTAT1}$ is connected to a power supply. The second capacitively-biased diode circuit comprises a second PTAT circuit switch $S_{PTAT2}$, a second PTAT diode branch and a second PTAT capacitor branch. One end of the second PTAT circuit switch $S_{PTAT2}$ is connected to one end of the second PTAT diode branch and one end of the second PTAT capacitor branch respectively, and the other end of the second PTAT diode branch and the other end of the second PTAT capacitor branch are both grounded; and the other end of the second PTAT circuit switch $S_{PTAT2}$ is connected to the power supply.

The first PTAT diode branch comprises a second diode D2 and a third PTAT circuit switch $S_{PTAT3}$ connected to the connected to the second diode D2. The second PTAT diode branch comprises a fourth PTAT circuit switch $S_{PTAT4}$ and a PTAT diode combination connected to the fourth PTAT circuit switch $S_{PTAT4}$, and the PTAT diode combination comprises a plurality of third diodes D3 connected in parallel. When the digital output signal is an $N$-bit output, and $N$ is greater than 1, both the first PTAT capacitor branch and the second PTAT capacitor branch comprise $N$ parallel first capacitor branches, the first capacitor branch comprises a first reference capacitor $C_{REF1}$ and a first reference switch $S_{REF1}$ connected to the first reference capacitor $C_{REF1}$.

In this embodiment, $\alpha$ is adjusted by a relative proportion of the first reference capacitor $C_{REF1}$ and the second reference capacitor $C_{REF2}$, and $\alpha = C_{REF1}/C_{REF2}$.

In addition, the system calibration can be completed in one step since no additional reference signal generating circuit and no additional reference signal driver are needed. The embodiments of the present application provide a calibration method for an analog to digital converter integrated with reference voltage generation, which is applied to the above-mentioned analog to digital converter integrated with reference voltage generation, and is specifically implemented is as follows:

step 1: inputting an analog input signal to the analog to digital converter integrated with reference voltage generation to obtain a digital output signal;
step 2: differencing the digital output signal and an ideal value to obtain a difference value; and
step 3: adjusting a reference capacitor or a discharge duration of the capacitive digital to analog converter according to the difference value, thereby calibrating the digital output signal.

Further, the ideal value in the step 2 is a ratio of an analog input signal value to a reference signal value expected to be designed.

Further, in the step 3, the adjusting the reference capacitor of the capacitive digital to analog converter according to the difference value refers to adjusting a first reference capacitor $C_{REF1}$ or a second reference capacitor $C_{REF2}$, specifically comprising:

when the difference value is positive, increasing the first reference capacitor $C_{REF1}$ or the second reference capacitor $C_{REF2}$ until the difference value is zero; and
when the difference value is negative, decreasing the first reference capacitor $C_{REF1}$ or the second reference capacitor $C_{REF2}$ until the difference value is zero.

Further, in the step 3, the adjusting the discharge duration of the capacitive digital to analog converter according to the difference value refers to adjusting discharge durations of switching on a third PTAT circuit switch $S_{PTAT3}$ and a fourth PTAT circuit switch $S_{PTAT4}$, specifically comprising:

when the difference value is positive, decreasing a discharge duration of the first reference capacitor $C_{REF1}$ or the second reference capacitor $C_{REF2}$ until the difference value is zero; and
when the difference value is positive, increasing the discharge duration of the first reference capacitor $C_{REF1}$ or the second reference capacitor $C_{REF2}$ until the difference value is zero.

The discharge duration t may be made adjustable, such as t shown in a waveform diagram of FIG. 4. The time delay t may be obtained by counting an external highfrequency clock during specific implementation, and t may also be obtained by on-chip RC delay. To make t adjustable, it is only needed to make a counting number or an RC value adjustable, thus being capable of controlling the duration t.

The above solutions can calibrate all system errors such as ADC and reference signal through one calibration, so there is no need for additional reference signal or driver calibration.

In a specific implementation, the present application provides a computer storage medium and a corresponding data processing unit, wherein the computer storage medium is capable of storing a computer program, and the computer program, when executed by the data processing unit, can run the inventive contents of the calibration method for the analog to digital converter integrated with reference voltage generation provided by the present invention and some or all steps in various embodiments. The storage medium may be a magnetic disk, an optical disk, a read-only memory (ROM) or a random access memory (RAM).

Those skilled in the art can clearly understand that the technical solutions in the embodiments of the present invention can be realized by means of a computer program and a corresponding general hardware platform thereof. Based on such understanding, the essence of the technical solutions in the embodiments of the present invention or the part contributing to the prior art, may be embodied in the form of a computer program, i.e., a software product. The computer program, i.e., the software product may be stored in a storage medium comprising a number of instructions such that one device (which may be a personal computer, a server, a singlechip, a MUU or a network device, and the like) comprising the data processing unit executes the methods described in various embodiments or some parts of the embodiments of the present invention.

The present invention provides the analog to digital converter integrated with reference voltage generation and the calibration method calibration method. There are many methods and ways to realize the technical solutions. The above only describes the specific embellishments of the present invention. It should be pointed out that those of ordinary skills in the art can make some improvements and embellishments without departing from the principle of the present invention, and these improvements and embellishments should also be regarded as falling with the scope of protection of the present invention defined by the appended claims. All the unspecified components in the embodiments can be realized by the prior art.

**Claims**

1. An analog to digital converter integrated with reference voltage generation, comprising a sample-hold circuit, a capacitive digital to analog converter and a quantizer, wherein:

the sample-and-hold circuit is configured for sampling and holding an analog input signal to obtain a first signal;
the capacitive digital to analog converter is configured for generating a reference signal and generating a second signal in equal proportion to the reference signal according to a feedback digital output signal, and differencing the first signal and the second signal to obtain an error signal; and
the quantizer is configured for digitizing the error signal to obtain a digital output signal;
the capacitive digital to analog converter comprises a CTAT circuit based on a capacitively-biased diode, the CTAT circuit based on the capacitively-biased diode generates a CTAT voltage $V_D$ which decreases with the increase of temperature;
wherein the CTAT circuit based on the capacitively-biased diode comprises a first CTAT circuit switch $S_{CTAT1}$, a CTAT diode branch and a CTAT capacitor branch, one end of the first CTAT circuit switch $S_{CTAT1}$ is connected to one end of the CTAT diode branch and one end of the CTAT capacitor branch respectively, and the other end of the CTAT diode branch and the other end of the CTAT capacitor branch are both grounded; and the other end of the first CTAT circuit switch $S_{CTAT1}$ is connected to a power supply,
wherein the CTAT diode branch comprises a first diode D1 and a second CTAT circuit switch $S_{CTAT2}$ connected to the first diode D1;
the CTAT capacitor branch comprises a second reference capacitor $C_{REF2}$;
wherein the second reference capacitor $C_{REF2}$ is pre-charged to a power supply voltage $V_{DD}$ through the first CTAT circuit switch $S_{CAT1}$, then the first CTAT circuit switch $S_{CAT1}$ is switched off, the second CTAT circuit switch $S_{CTAT2}$ is switched on, and the second reference capacitor $C_{REF2}$ is discharged through the first diode D1; and when a residual voltage on the second reference capacitor $C_{REF2}$ decreases with the increase of temperature in a fixed discharge duration, the residual voltage is the CTAT voltage $V_D$,
wherein the capacitive digital to analog converter comprises a PTAT circuit, which comprises a first capacitively-biased diode circuit and a second capacitively-biased diode circuit,
wherein a first reference capacitor $C_{REF1}$ of the first capacitively-biased diode circuit is pre-charged to the power supply voltage $V_{DD}$ through a first PTAT circuit switch $S_{PTAT1}$, then the first PTAT circuit switch $S_{PTAT1}$ is switched off and a third PTAT circuit switch $S_{PTAT3}$ is switched on, and the first reference capacitor $C_{REF1}$ of the first capacitively-biased diode circuit is discharged through a second diode D2 to obtain a first residual voltage $V_{D1}$,
wherein a first reference capacitor $C_{REF1}$ of the second capacitively-biased diode circuit is pre-charged to the power supply voltage $V_{DD}$ through a second PTAT circuit switch $S_{PTAT2}$, then the second PTAT circuit switch $S_{PTAT2}$ is switched off, a fourth PTAT circuit switch $S_{PTAT4}$

is switched on, and the first reference capacitor $C_{REF1}$ of the second capacitively-biased diode circuit is discharged through a PTAT diode combination,

comprising p third diodes D3 connected in parallel, wherein p is greater than 1, to obtain a second residual voltage $V_{D2}$.

2. The analog to digital converter integrated with reference voltage generation according to claim 1, wherein the CTAT circuit based on the capacitively-biased diode and the PTAT circuit based on the capacitively-biased diode jointly generate the reference signal, and the reference signal is independent of temperature.

3. The analog to digital converter integrated with reference voltage generation according to claim 2, wherein the PTAT circuit based on the capacitively-biased diode generates a PTAT voltage $\Delta V_D$ which increases with the increase of temperature, the CTAT voltage $V_D$ and the PTAT voltage $\Delta V_D$ are combined and added to generate a reference voltage $V_{REF}$ of the reference signal, $V_{REF} = \alpha \Delta V_D + V_D$, $\alpha$ is a scale factor, and a value of the scale factor $\alpha$ makes the reference voltage $V_{REF}$ independent of temperature.

4. The analog to digital converter integrated with reference voltage generation according to claim 3, wherein the PTAT circuit based on the capacitively-biased diode comprises the first capacitively-biased diode circuit and the second capacitively-biased diode circuit, the first capacitively-biased diode circuit comprises the first PTAT circuit switch $S_{PTAT1}$, a first PTAT diode branch and a first PTAT capacitor branch, one end of the first PTAT circuit switch $S_{PTAT1}$ is respectively connected to one end of the first PTAT diode branch and one end of the first PTAT capacitor branch, and the other end of the first PTAT diode branch and the other end of the first PTAT capacitor branch are both grounded; and the other end of the first PTAT circuit switch $S_{PTAT1}$ is connected to the power supply; and the second capacitively-biased diode circuit comprises the second PTAT circuit switch $S_{PTAT2}$, a second PTAT diode branch and a second PTAT capacitor branch, one end of the second PTAT circuit switch $S_{PTAT2}$ is connected to one end of the second PTAT diode branch and one end of the second PTAT capacitor branch respectively, and the other end of the second PTAT diode branch and the other end of the second PTAT capacitor branch are both grounded; and the other end of the second PTAT circuit switch $S_{PTAT2}$ is connected to the power supply.

5. The analog to digital converter integrated with reference voltage generation according to claim 4, wherein when the digital output signal is a 1-bit digital output, the CTAT capacitor branch comprises the second reference capacitor $C_{REF2}$.

6. The analog to digital converter integrated with reference voltage generation according to claim 4, wherein when the digital output signal is an N-bit output, and N is greater than 1, the CTAT capacitor branch comprises N parallel second capacitor branches, each second capacitor branch comprises a second reference capacitor $C_{REF2}$ and a second reference switch $S_{REF2}$ connected to the second reference capacitor $C_{REF2}$.

7. The analog to digital converter integrated with reference voltage generation according to claim 5 or 6, wherein the first PTAT diode branch comprises the second diode D2 and the third PTAT circuit switch $S_{PTAT3}$ connected to the second diode D2.

8. The analog to digital converter integrated with reference voltage generation according to claim 7, wherein the second PTAT diode branch comprises the fourth PTAT circuit switch $S_{PTAT4}$ and the PTAT diode combination connected to the fourth PTAT circuit switch $S_{PTAT4}$.

9. The analog to digital converter integrated with reference voltage generation according to claim 8, wherein when the digital output signal is a 1-bit digital output, both the first PTAT capacitor branch and the second PTAT capacitor branch comprise a first reference capacitor $C_{REF1}$.

10. The analog to digital converter integrated with reference voltage generation according to claim 8, wherein when the digital output signal is an N-bit output, and N is greater than 1, both the first PTAT capacitor branch and the second PTAT capacitor branch comprise N parallel first capacitor branches, each first capacitor branch comprises a first reference capacitor $C_{REF1}$ and a first reference switch $S_{REF1}$ connected to the first reference capacitor $C_{REF1}$.

11. The analog to digital converter integrated with reference voltage generation according to claim 10, wherein a voltage difference $V_{D1}$-$V_{D2}$ between the first residual voltage $V_{D1}$ and the second residual voltage $V_{D2}$ increases with the increase of temperature, and the voltage difference is the PTAT voltage $\Delta V_D$.

12. The analog to digital converter integrated with reference voltage generation according to claim 11, wherein the first CTAT circuit switch $S_{CTAT1}$, control timing sequences of the first PTAT circuit switch

$S_{PTAT1}$ and the second PTAT circuit switch $S_{PTAT2}$ are the same.

13. The analog to digital converter integrated with reference voltage generation according to claim 12, wherein control timing sequences of the second CTAT circuit switch $S_{CTAT2}$, the third PTAT circuit switch $S_{PTAT3}$ and the fourth PTAT circuit switch $S_{PTAT4}$ are the same, and a ratio of an area of the second diode D2 to an area of the PTAT diode combination is set as 1: $p$, and $p$ is greater than 1.

14. The analog to digital converter integrated with reference voltage generation according to claim 13, wherein control timing sequences of the second CTAT circuit switch $S_{CTAT2}$ and the third PTAT circuit switch $S_{PTAT3}$ are the same, an area of the second diode D2 is equal to an area of the PTAT diode combination, starting times of switching on the third PTAT circuit switch $S_{PTAT3}$ and the fourth PTAT circuit switch $S_{PTAT4}$ are the same, a ratio of durations switching on is 1: $p$, and $p$ is greater than 1.

15. The analog to digital converter integrated with reference voltage generation according to claim 9 or 10, wherein the analog to digital converter is a Delta-Sigma analog to digital converter, the Delta-Sigma analog to digital converter comprises a Delta-Sigma modulator, the Delta-Sigma modulator comprises the capacitive digital to analog converter and a first-order integrator, the capacitive digital to analog converter generates the CTAT voltage $V_D$ and the PTAT voltage $\Delta V_D$, the CTAT voltage $V_D$ and the PTAT voltage $\Delta V_D$ are added and combined by the first-order integrator to obtain a reference signal reference $V_{REF}=\alpha\Delta V_D+V_D$, wherein $\alpha=C_{REF1}/C_{REF2}$.

16. The analog to digital converter integrated with reference voltage generation according to claim 15, wherein the first-order integrator comprises an integrating capacitor $C_{INT}$, and a control timing sequence of the Delta-Sigma modulator comprises: realizing signal sampling of an input signal $V_{IN}$ in a sampling period $\Phi1$ and realizing signal transferring and integrating in an integrating period $\Phi2$; wherein, for a reference signal branch, the sampling period $\Phi1$ is divided into two parts: rst and $\Phi3$, wherein in the rst state, the first reference capacitor $C_{REF1}$ and the second reference capacitor $C_{REF2}$ are pre-charged to the power supply voltage; in the $\Phi3$ state, the second reference capacitor $C_{REF2}$ is discharged through the first diode D1, the first reference capacitor $C_{REF1}$ is discharged through the second diode D2 and the PTAT diode combination, and the reference signal is sampled at the first reference capacitor $C_{REF1}$ and the second reference capacitor $C_{REF2}$ at the end of $\varphi3$ and $\varphi1$; and in an integrating phase $\Phi2$, charges on the first reference capacitor $C_{REF1}$ and the second reference capacitor $C_{REF2}$ are transferred to the integrating capacitor $C_{INT}$.

17. The analog to digital converter integrated with reference voltage generation according to claim 16, wherein when the Delta-Sigma modulator outputs a 1-bit BS code stream, +/-$V_{REF}$ is generated according to the output 1-bit BS code stream, which is used for balancing with the input signal $V_{IN}$, and an average value of the BS code stream is $V_{IN}/V_{REF}$.

18. The analog to digital converter integrated with reference voltage generation according to claim 10, wherein the analog to digital converter is a charge-sharing successive approximation register analog to digital converter, the successive approximation register analog to digital converter comprises an input capacitor CIN, the capacitive digital to analog converter and a comparator, and the capacitive digital to analog converter samples the reference signal independent of temperature on the N-bit first reference capacitor $C_{REF1}$ and the second reference capacitor $C_{REF2}$ in a sampling stage, and generates a feedback control signal in equal proportion to the reference signal according to comparator results in a comparison stage.

19. The analog to digital converter integrated with reference voltage generation according to claim18, wherein in the capacitive digital to analog converter, one end of the first CTAT circuit switch $S_{CTAT1}$ of the CTAT circuit based on the capacitively-biased diode is also connected to a sixth CTAT circuit switch $S_{CTAT6}$, and when the digital output signal is an $N$-bit digital output, and $N$ is greater than 1, the CTAT capacitor branch comprises $N$ parallel second capacitor branches, the second capacitor branch comprises the second reference capacitor $C_{REF2}$, and the second reference switch $S_{REF2}$ connected to the second reference capacitor $C_{REF2}$, and further comprises a fourth reference switch $S_{REF4}$ connected to the second reference capacitor $C_{REF2}$, and the fourth reference switch $S_{REF4}$ is connected to an MSB or an LSB; and

in the PTAT circuit based on the capacitively-biased diode, one end of the first PTAT circuit switch $S_{PTAT1}$ is also connected to a seventh PTAT circuit switch $S_{PTAT7}$, one end of the second PTAT circuit switch $S_{PTAT2}$ is connected to the seventh PTAT circuit switch $S_{PTAT7}$, the first PTAT capacitor branch and the second PTAT capacitor branch both comprise $N$ parallel first capacitor branches, the first capacitor branch comprises the first reference capacitor $C_{REF1}$, and the first reference switch $S_{REF1}$ connected to the first reference capacitor $C_{REF1}$, and further comprises a third reference switch $S_{REF3}$ connected to the first reference capacitor $C_{REF1}$,

and the third reference switch $S_{REF3}$ is connected to the MSB or the LSB; the second PTAT capacitor branch further comprises an eighth PTAT circuit switch $S_{PTAT8}$, one end of the eighth PTAT circuit switch $S_{PTAT8}$ is connected to the N parallel first capacitor branches, and the other end of the eighth PTAT circuit switch $S_{PTAT8}$ is grounded; and one end of the eighth PTAT circuit switch $S_{PTAT8}$ is also connected to the sixth CTAT circuit switch $S_{CTAT6}$.

20. The analog to digital converter integrated with reference voltage generation according to claim 19, wherein a control timing sequence of the charge-sharing successive approximation register analog to digital converter comprises: sampling and holding an input signal on an input capacitor CIN, and holding a reference voltage of the reference signal on the first reference capacitor $C_{REF1}$ and the second reference capacitor $C_{REF2}$; differencing input signals INP and INN to realize signal sampling held on the input capacitor CIN when a sampling phase Fs is high, and for the reference signal branch, accessing the first reference capacitor $C_{REF1}$ to the circuit at the sampling phase Fs through first reference switch $S_{REF1}$ and third reference switch $S_{REF3}$, and accessing the second reference capacitor $C_{REF2}$ to the circuit at the sampling phase Fs through the second reference switch $S_{REF2}$ and fourth reference switch $S_{REF4}$ into the circuit to generate the reference signal; wherein the sampling phase Fs is detachable into two parts: a $\Phi1$ phase and a $\Phi2$ phase, the $\Phi1$ phase realizes generation of a PTAT voltage signal $\Delta V_D$ which is positively related to temperature and a CTAT voltage signal $V_D$ which is negatively related to temperature; and the $\varphi2$ phase realizes proportional addition of the PTAT voltage signal $\Delta V_D$ and the CTAT voltage signal $V_D$ to obtain a reference signal $\alpha\Delta V_D+V_D$ which is independent of temperature; wherein, for the generation of the PTAT voltage signal $\Delta V_D$ and the CTAT voltage signal $V_D$, the $\Phi1$ phase is further divided into two sub-phases: rst and $\Phi d/\Phi d1,2$; in the rst state, the first reference capacitor $C_{REF1}$ and the second reference capacitor $C_{REF2}$ are pre-charged to the power supply voltage $V_{DD}$; in the $\Phi d$ state, the second reference capacitor $C_{REF2}$ is discharge through the first diode D1, in the $\Phi d1$ and $\Phi d2$ states, the first reference capacitor $C_{REF1}$ is discharged through the second diode D2 and a combination of the third diodes D3, and at the end of $\Phi1$, $\Phi d$ and $\Phi d1,2$, the PTAT voltage signal $\Delta V_D$ and the CTAT voltage signal $V_D$ are respectively sampled at the first reference capacitor $C_{REF1}$ and the second reference capacitor $C_{REF2}$; and at the $\Phi2$ phase, the eighth PTAT circuit switch $S_{PTAT8}$ is switched off, while the sixth CTAT circuit switch $S_{PTAT6}$ and the seventh PTAT circuit switch $S_{PTAT7}$ are switched on, so that the PTAT voltage signal $\Delta V_D$ and the CTAT voltage signal $V_D$ are added, and the reference signal independent of temperature is generated at the first reference capacitor $C_{REF1}$ and the second reference capacitor $C_{REF2}$; and
after the sampling phase Fs ends, entering a comparative quantization phase $\Phi_{SAR}$, and sharing charges among the first reference capacitor $C_{REF1}$, the second reference capacitor $C_{REF2}$ and the input capacitor CIN through an algorithm logic of successive approximation to obtain a comparator input voltage, and comparing, by the comparator, results obtained to control next working state of the capacitive digital to analog converter; and performing multiple successive approximation comparison to obtain the finally converted output signal.

21. The analog to digital converter integrated with reference voltage generation according to claim 9 or 10, wherein the analog to digital converter is a pipelined analog to digital converter, and the pipelined analog to digital converter comprises conversion modules cascaded in series stage by stage, wherein the conversion module in each stage comprises the sample-and-hold circuit and the capacitive digital-to-analog converter, and the sample-and-hold circuit samples and holds an analog input signal to obtain a first signal; the conversion module in each step comprises the sample-hold circuit and the capacitive digital to analog converter, and the sample-hold circuit performs sampling and holding on the analog input signal to obtain the first signal; the capacitive digital to analog converter generates the reference signal and generates the second signal in equal proportion to the reference signal according to the feedback digital output signal, and the first signal and the second signal are differenced to obtain the error signal.

22. A calibration method for an analog to digital converter integrated with reference voltage generation applied to the analog to digital converter integrated with reference voltage generation according to any one of claims 10 to 21, comprising:

step 1: inputting an analog input signal to the analog to digital converter integrated with reference voltage generation to obtain a digital output signal;
step 2: differencing the digital output signal and an ideal value to obtain a difference value; and
step 3: adjusting a reference capacitor or a discharge duration of the capacitive digital to analog converter according to the difference value, thereby calibrating the digital output signal.

23. The calibration method for the analog to digital converter integrated with reference voltage generation according to claim 22, wherein the ideal value in the step 2 is a ratio of an analog input signal value to a reference signal value expected to be designed.

24. The calibration method for the analog to digital converter integrated with reference voltage generation according to claim 23, wherein the step 3 comprises:

when the difference value is positive, increasing a first reference capacitor $C_{REF1}$ or a second reference capacitor $C_{REF2}$ until the difference value is zero; and

when the difference value is negative, decreasing the first reference capacitor $C_{REF1}$ or the second reference capacitor $C_{REF2}$ until the difference value is zero.

25. The calibration method for the analog to digital converter integrated with reference voltage generation according to claim 24, wherein the step 3 comprises:

when the difference value is positive, decreasing a discharge duration of the first reference capacitor $C_{REF1}$ or the second reference capacitor $C_{REF2}$ until the difference value is zero; and

when the difference value is positive, increasing the discharge duration of the first reference capacitor $C_{REF1}$ or the second reference capacitor $C_{REF2}$ until the difference value is zero.

**Patentansprüche**

1. Analog-Digital-Wandler mit integrierter Referenzspannungserzeugung, umfassend einen Abtast-Halte-Kreis, einen kapazitiven Digital-Analog-Wandler und einen Quantisierer, wobei:

der Abtast- und Halte-Kreis zum Abtasten und Halten eines analogen Eingangssignals konfiguriert ist, um ein erstes Signal zu erhalten;

der kapazitive Digital-Analog-Wandler zum Erzeugen eines Referenzsignals und Erzeugen eines zweiten Signals in gleichem Verhältnis zu dem Referenzsignal gemäß einem digitalen Rückkopplungsausgabesignal und Differenzieren des ersten Signals und des zweiten Signals, um ein Fehlersignal zu erhalten, konfiguriert ist; und

der Quantisierer zum Digitalisieren des Fehlersignals konfiguriert ist, um ein digitales Ausgabesignal zu erhalten;

der kapazitive Digital-Analog-Wandler einen CTAT-Kreis auf Basis einer kapazitiv vorgespannten Diode umfasst, wobei der CTAT-Kreis auf Basis der kapazitiv vorgespannten Diode eine CTAT-Spannung $V_D$ erzeugt, die mit der Erhöhung der Temperatur abnimmt;

wobei der CTAT-Kreis auf Basis der kapazitiv vorgespannten Diode einen ersten CTAT-Kreis-Schalter $S_{CTAT1}$, einen CTAT-Diodenabzweig und einen CTAT-Kondensatorabzweig umfasst, ein Ende des ersten CTAT-Kreis-Schalters $S_{CTAT1}$ jeweils mit einem Ende des CTAT-Diodenabzweigs und einem Ende des CTAT-Kondensatorabzweigs verbunden ist und das andere Ende des CTAT-Diodenabzweigs und das andere Ende des CTAT-Kondensatorabzweigs beide geerdet sind; und das andere Ende des ersten CTAT-Kreis-Schalters $S_{CTAT1}$ mit einer Leistungsversorgung verbunden ist,

wobei der CTAT-Diodenabzweig eine erste Diode D1 und einen zweiten CTAT-Kreis-Schalter $S_{CTAT2}$ umfasst, der mit der ersten Diode D1 verbunden ist;

der CTAT-Kondensatorabzweig einen zweiten Referenzkondensator $C_{REF2}$ umfasst;

wobei der zweite Referenzkondensator $C_{REF2}$ auf eine Leistungsversorgungsspannung $V_{DD}$ über den ersten CTAT-Kreis-Schalter $S_{CAT1}$ vorgeladen wird, dann der erste CTAT-Kreis-Schalter $S_{CAT1}$ ausgeschaltet wird, der zweite CTAT-Kreis-Schalter $S_{CTAT2}$ eingeschaltet und der zweite Referenzkondensator $C_{REF2}$ über die erste Diode D1 entladen wird; und wenn eine Restspannung an dem zweiten Referenzkondensator $C_{REF2}$ mit der Erhöhung der Temperatur bei fester Entladedauer abnimmt, die Restspannung die CTAT-Spannung $V_D$ ist,

wobei der kapazitive Digital-Analog-Wandler einen PTAT-Kreis umfasst, der einen ersten kapazitiv vorgespannten Diodenkreis und einen zweiten kapazitiv vorgespannten Diodenkreis umfasst,

wobei ein erster Referenzkondensator $C_{REF1}$ des ersten kapazitiv vorgespannten Diodenkreises auf die Leistungsversorgungsspannung $V_{DD}$ über einen ersten PTAT-Kreis-Schalter $S_{PTAT1}$ vorgeladen wird, dann der erste PTAT-Kreis-Schalter $S_{PTAT1}$ ausgeschaltet wird und ein dritter PTAT-Kreis-Schalter $S_{PTAT3}$ eingeschaltet wird und der erste Referenzkondensator $C_{REF1}$ des ersten kapazitiv vorgespannten Diodenkreises über eine zweite Diode D2 entladen wird, um eine erste Restspannung $V_{D1}$ zu erhalten,

wobei ein erster Referenzkondensator $C_{REF1}$ des zweiten kapazitiv vorgespannten Diodenkreises auf die Leistungsversorgungsspannung $V_{DD}$ über einen zweiten PTAT-Kreis-Schalter $S_{PTAT2}$ vorgeladen wird, dann der zweite PTAT-Kreis-Schalter $S_{PTAT2}$ ausgeschaltet wird, ein vierter PTAT-Kreis-Schalter $S_{PTAT4}$ eingeschaltet wird und der erste Referenzkondensator $C_{REF1}$ des zweiten kapazitiv vorgespannten Diodenkreises über eine PTAT-Diodenkombination entladen wird, die p dritte Dioden D3 umfasst, die parallel verbunden sind, wobei p größer als 1 ist, um eine zweite Restspannung $V_{D2}$ zu erhalten.

2.  Analog-Digital-Wandler mit integrierter Referenzspannungserzeugung gemäß Anspruch 1, wobei der CTAT-Kreis auf Basis der kapazitiv vorgespannten Diode und der PTAT-Kreis auf Basis der kapazitiv vorgespannten Diode gemeinsam das Referenzsignal erzeugen und das Referenzsignal temperaturunabhängig ist.

3.  Analog-Digital-Wandler mit integrierter Referenzspannungserzeugung gemäß Anspruch 2, wobei der PTAT-Kreis auf Basis der kapazitiv vorgespannten Diode eine PTAT-Spannung $\Delta V_D$ erzeugt, die sich mit der Temperaturerhöhung erhöht, die CTAT-Spannung $V_D$ und die PTAT-Spannung $\Delta V_D$ kombiniert und addiert werden, um eine Referenzspannung $V_{REF}$ des Referenzsignals zu erzeugen, $V_{REF}=\alpha\Delta V_D+V_D$, $\alpha$ ein Skalenfaktor ist und ein Wert des Skalenfaktors $\alpha$ die Referenzspannung $V_{REF}$ temperaturunabhängig macht.

4.  Analog-Digital-Wandler mit integrierter Referenzspannungserzeugung gemäß Anspruch 3, wobei der PTAT-Kreis auf Basis der kapazitiv vorgespannten Diode den ersten kapazitiv vorgespannten Diodenkreis und den zweiten kapazitiv vorgespannten Diodenkreis umfasst, der erste kapazitiv vorgespannte Diodenkreis den ersten PTAT-Kreis-Schalter $S_{PTAT1}$, einen ersten PTAT-Diodenabzweig und einen ersten PTAT-Kondensatorabzweig umfasst, ein Ende des ersten PTAT-Kreis-Schalters $S_{PTAT1}$ jeweils mit einem Ende des ersten PTAT-Diodenabzweigs und einem Ende des ersten PTAT-Kondensatorabzweigs verbunden ist und das andere Ende des ersten PTAT-Diodenabzweigs und das andere Ende des ersten PTAT-Kondensatorabzweigs beide geerdet sind; und das andere Ende des ersten PTAT-Kreis-Schalters $S_{PTAT1}$ mit der Leistungsversorgung verbunden ist; und
der zweite kapazitiv vorgespannte Diodenkreis den zweiten PTAT-Kreis-Schalter $S_{PTAT2}$, einen zweiten PTAT-Diodenabzweig und einen zweiten PTAT-Kondensatorabzweig umfasst, ein Ende des zweiten PTAT-Kreis-Schalters $S_{PTAT2}$ jeweils mit einem Ende des zweiten PTAT-Diodenabzweigs und einem Ende des zweiten PTAT-Kondensatorabzweigs verbunden ist und das andere Ende des zweiten PTAT-Diodenabzweigs und das andere Ende des zweiten PTAT-Kondensatorabzweigs beide geerdet sind; und das andere Ende des zweiten PTAT-Kreis-Schalters $S_{PTAT2}$ mit der Leistungsversorgung verbunden ist.

5.  Analog-Digital-Wandler mit integrierter Referenzspannungserzeugung gemäß Anspruch 4, wobei, wenn das digitale Ausgabesignal eine digitale 1-Bit-Ausgabe ist, der CTAT-Kondensatorabzweig den zweiten Referenzkondensator $C_{REF2}$ umfasst.

6.  Analog-Digital-Wandler mit integrierter Referenzspannungserzeugung gemäß Anspruch 4, wobei, wenn das digitale Ausgabesignal eine *N*-Bit-Ausgabe ist und *N* größer als 1 ist, der CTAT-Kondensatorabzweig *N* parallele zweite Kondensatorabzweige umfasst, jeder zweite Kondensatorabzweig einen zweiten Referenzkondensator $C_{REF2}$ und einen zweiten Referenzschalter $S_{REF2}$ umfasst, der mit dem zweiten Referenzkondensator $C_{REF2}$ verbunden ist.

7.  Analog-Digital-Wandler mit integrierter Referenzspannungserzeugung gemäß Anspruch 5 oder 6, wobei der erste PTAT-Diodenabzweig die zweite Diode D2 und den dritten PTAT-Kreis-Schalter $S_{PTAT3}$ umfasst, der mit der zweiten Diode D2 verbunden ist.

8.  Analog-Digital-Wandler mit integrierter Referenzspannungserzeugung gemäß Anspruch 7, wobei der zweite PTAT-Diodenabzweig den vierten PTAT-Kreis-Schalter $S_{PTAT4}$ und die PTAT-Diodenkombination umfasst, die mit dem vierten PTAT-Kreis-Schalter $S_{PTAT4}$ verbunden ist.

9.  Analog-Digital-Wandler mit integrierter Referenzspannungserzeugung gemäß Anspruch 8, wobei, wenn das digitale Ausgabesignal eine digitale 1-Bit-Ausgabe ist, sowohl der erste PTAT-Kondensatorabzweig als auch der zweite PTAT-Kondensatorabzweig einen ersten Referenzkondensator $C_{REF1}$ umfassen.

10. Analog-Digital-Wandler mit integrierter Referenzspannungserzeugung gemäß Anspruch 8, wobei, wenn das digitale Ausgabesignal eine N-Bit-Ausgabe ist und *N* größer als 1 ist, sowohl der erste PTAT-Kondensatorabzweig als auch der zweite PTAT-Kondensatorabzweig *N* parallele erste Kondensatorabzweige umfassen, jeder erste Kondensatorabzweig einen ersten Referenzkondensator $C_{REF1}$ und einen ersten Referenzschalter $S_{REF1}$ umfasst, der mit dem ersten Referenzkondensator $C_{REF1}$ verbunden ist.

11. Analog-Digital-Wandler mit integrierter Referenzspannungserzeugung gemäß Anspruch 10, wobei eine Spannungsdifferenz $V_{D1}$-$V_{D2}$ zwischen der ersten Restspannung $V_{D1}$ und der zweiten Restspannung $V_{D2}$ sich mit der Temperaturerhöhung erhöht und die Spannungsdifferenz die PTAT-Spannung $\Delta V_D$ ist.

12. Analog-Digital-Wandler mit integrierter Referenzspannungserzeugung gemäß Anspruch 11, wobei der erste CTAT-Kreis-Schalter $S_{CTAT1}$, Steuerzeitabläufe des ersten PTAT-Kreis-Schalters $S_{PTAT1}$ und des zweiten PTAT-Kreis-Schalters $S_{PTAT2}$ gleich sind.

13. Analog-Digital-Wandler mit integrierter Referenzspannungserzeugung gemäß Anspruch 12, wobei Steuerzeitabläufe des zweiten CTAT-Kreis-Schalters $S_{CTAT2}$, des dritten PTAT-Kreis-Schalters $S_{PTAT3}$ und des vierten PTAT-Kreis-Schalters $S_{PTAT4}$ gleich sind und ein Verhältnis einer Fläche der zweiten Diode D2 zu einer Fläche der PTAT-Diodenkombination als 1: *p* eingestellt ist und *p* größer als 1 ist.

14. Analog-Digital-Wandler mit integrierter Referenzspannungserzeugung gemäß Anspruch 13, wobei Steuerzeitabläufe des zweiten CTAT-Kreis-Schalters $S_{CTAT2}$ und des dritten PTAT-Kreis-Schalters $S_{PTAT3}$ gleich sind, eine Fläche der zweiten Diode D2 gleich einer Fläche der PTAT-Diodenkombination ist, Startzeitpunkte eines Einschaltens des dritten PTAT-Kreis-Schalters $S_{PTAT3}$ und des vierten PTAT-Kreis-Schalters $S_{PTAT4}$ gleich sind, ein Verhältnis der Einschaltdauern 1: *p* ist und *p* größer als 1 ist.

15. Analog-Digital-Wandler mit integrierter Referenzspannungserzeugung gemäß Anspruch 9 oder 10, wobei der Analog-Digital-Wandler ein Delta-Sigma-Analog-Digital-Wandler ist, der Delta-Sigma-Analog-Digital-Wandler einen Delta-Sigma-Modulator umfasst, der Delta-Sigma-Modulator den kapazitiven Digital-Analog-Wandler und einen Integrator erster Ordnung umfasst, der kapazitive Digital-Analog-Wandler die CTAT-Spannung $V_D$ und die PTAT-Spannung $\Delta V_D$ erzeugt, die CTAT-Spannung $V_D$ und die PTAT-Spannung $\Delta V_D$ addiert und durch den Integrator erster Ordnung kombiniert werden, um eine Referenzsignalreferenz $V_{REF}=\alpha \Delta V_D+V_D$ zu erhalten, wobei $\alpha=C_{REF1}/C_{REF2}$.

16. Analog-Digital-Wandler mit integrierter Referenzspannungserzeugung gemäß Anspruch 15, wobei der Integrator erster Ordnung einen Integrationskondensator $C_{INT}$ umfasst und eine Steuerzeitabfolge des Delta-Sigma-Modulators Folgendes umfasst: Realisieren einer Signalabtastung eines Eingangssignals $V_{IN}$ in einer Abtastperiode Φ1 und Realisieren einer Signalübertragung und -integrierung in einer Integrationsperiode Φ2; wobei für einen Referenzsignalabzweig die Abtastperiode Φ1 in zwei Teile unterteilt ist: rst und Φ3, wobei in dem rst-Zustand der erste Referenzkondensator $C_{REF1}$ und der zweite Referenzkondensator $C_{REF2}$ auf die Stromversorgungsspannung vorgeladen sind; in dem Φ3-Zustand der zweite Referenzkondensator $C_{REF2}$ über die erste Diode D1 entladen wird, der erste Referenzkondensator $C_{REF1}$ über die zweite Diode D2 und die PTAT-Diodenkombination entladen wird und das Referenzsignal an dem ersten Referenzkondensator $C_{REF1}$ und an dem zweiten Referenzkondensator $C_{REF2}$ an dem Ende von φ3 und φ1 abgetastet wird; und in einer Integrationsphase Φ2 Ladungen an dem ersten Referenzkondensator $C_{REF1}$ und dem zweiten Referenzkondensator $C_{REF2}$ auf den Integrationskondensator $C_{INT}$ übertragen werden.

17. Analog-Digital-Wandler mit integrierter Referenzspannungserzeugung gemäß Anspruch 16, wobei, wenn der Delta-Sigma-Modulator einen 1-Bit-BS-Codestrom ausgibt, +/-$V_{REF}$ gemäß dem ausgegebenen 1-Bit-BS-Codestrom erzeugt wird, der zum Abgleich mit dem Eingangssignal $V_{IN}$ verwendet wird, und ein Durchschnittswert des BS-Codestroms $V_{IN}/V_{REF}$ ist.

18. Analog-Digital-Wandler mit integrierter Referenzspannungserzeugung gemäß Anspruch 10, wobei der Analog-Digital-Wandler ein Analog-Digital-Wandler mit Ladungsverteilung und Sukzessivnäherungsregister ist, der Analog-Digital-Wandler mit Sukzessivnäherungsregister einen Eingangskondensator CIN, den kapazitiven Digital-Analog-Wandler und einen Komparator umfasst und der kapazitive Digital-Analog-Wandler das Referenzsignal unabhängig von der Temperatur an dem ersten N-Bit-Referenzkondensator $C_{REF1}$ und dem zweiten Referenzkondensator $C_{REF2}$ in einer Abtaststufe abtastet und ein Rückkopplungssteuersignal in gleichem Verhältnis zu dem Referenzsignal gemäß Komparatorergebnissen in einer Vergleichsstufe erzeugt.

19. Analog-Digital-Wandler mit integrierter Referenzspannungserzeugung gemäß Anspruch 18, wobei in dem kapazitiven Digital-Analog-Wandler ein Ende des ersten CTAT-Kreis-Schalters $S_{CTAT1}$ des CTAT-Kreises auf Basis der kapazitiv vorgespannten Diode auch mit einem sechsten CTAT-Kreis-Schalter $S_{CTAT6}$ verbunden ist und, wenn das digitale Ausgabesignal eine digitale *N*-Bit-Ausgabe ist und *N* größer als 1 ist, der CTAT-Kondensatorabzweig *N* parallele zweite Kondensatorabzweige umfasst, der zweite Kondensatorabzweig den zweiten Referenzkondensator $C_{REF2}$ und den zweiten Referenzschalter $S_{REF2}$ umfasst, der mit dem zweiten Referenzkondensator $C_{REF2}$ verbunden ist, und ferner einen vierten Referenzschalter $S_{REF4}$ umfasst, der mit dem zweiten Referenzkondensator $C_{REF2}$ verbunden ist, und der vierte Referenzschalter $S_{REF4}$ mit einem MSB oder einem LSB verbunden ist; und in dem PTAT-Kreis auf Basis der kapazitiv vorgespannten Diode ein Ende des ersten PTAT-Kreis-Schalters $S_{PTAT1}$ auch mit einem siebten PTAT-Kreis-Schalter $S_{PTAT7}$ verbunden ist, ein Ende des zweiten PTAT-Kreis-Schalters $S_{PTAT2}$ mit dem siebten PTAT-Kreis-Schalter $S_{PTAT7}$ verbunden ist, der erste PTAT-Kondensatorabzweig und der zweite PTAT-Kondensatorabzweig beide $N$ parallele erste Kondensatorabzweige umfassen, der erste Kondensatorabzweig den ersten Referenzkondensator $C_{REF1}$ und den ersten Referenzschalter $S_{REF1}$ umfasst, der mit dem ersten Referenzkondensator $C_{REF1}$ verbunden ist, und ferner einen dritten Referenzschalter $S_{REF3}$ umfasst, der mit dem ersten Referenzkondensator $C_{REF1}$ verbunden ist, und der dritte Referenzschalter $S_{REF3}$ mit dem MSB oder dem LSB verbunden ist; der zweite PTAT-Kondensatorabzweig ferner einen achten PTAT-Kreis-Schalter $S_{PTAT8}$ umfasst, ein Ende des achten PTAT-Kreis-Schalters $S_{PTAT8}$ mit den N parallelen ersten Kondensatorabzweigen verbunden ist und das andere Ende des achten PTAT-Kreis-Schalters $S_{PTAT8}$ geerdet ist; und ein Ende des achten PTAT-Kreis-Schalters $S_{PTAT8}$ auch mit dem sechsten CTAT-Kreis-Schalter $S_{CTAT6}$ verbunden ist.

20. Analog-Digital-Wandler mit integrierter Referenzspannungserzeugung gemäß Anspruch 19, wobei eine Steuerzeitabfolge des Analog-Digital-Wandlers mit Ladungsverteilung und Sukzessivnäherungsregister Folgendes umfasst: Abtasten und Halten eines Eingangssignals an einem Eingangskondensator CIN und Halten einer Referenzspannung des Referenzsignals an dem ersten Referenzkondensator $C_{REF1}$ und dem zweiten Referenzkondensator $C_{REF2}$; Differenzieren der Eingangssignale INP und INN, um eine Signalabtastung zu realisieren, die an dem Eingangskondensator CIN gehalten wird, wenn eine Abtastphase Fs hoch ist, und für den Referenzsignalabzweig Zugreifen auf den ersten Referenzkondensator $C_{REF1}$ auf den Kreis in der Abtastphase Fs durch den ersten Referenzschalter $S_{REF1}$ und den dritten Referenzschalter $S_{REF3}$ und Zugreifen auf den zweiten Referenzkondensator $C_{REF2}$ auf den Kreis in der Abtastphase Fs durch den zweiten Referenzschalter $S_{REF2}$ und den vierten Referenzschalter $S_{REF4}$ in den Kreis, um das Referenzsignal zu erzeugen; wobei die Abtastphase Fs in zwei Teile trennbar ist: eine $\Phi1$-Phase und eine $\Phi2$-Phase, die $\Phi1$-Phase die Erzeugung eines PTAT-Spannungssignals $\Delta V_D$, das in positiver Beziehung zur Temperatur steht, und eines CTAT-Spannungssignals $V_D$, das in negativer Beziehung zur Temperatur steht, realisiert; und die $\varphi2$-Phase eine proportionale Addition des PTAT-Spannungssignals $\Delta V_D$ und des CTAT-Spannungssignals $V_D$ realisiert, um ein temperaturunabhängiges Referenzsignal $\alpha\Delta V_D+V_D$ zu erhalten; wobei zur Erzeugung des PTAT-Spannungssignals $\Delta V_D$ und des CTAT-Spannungssignals $V_D$ die $\Phi1$-Phase weiter in zwei Unterphasen unterteilt wird: rst und $\Phi d/\Phi d1,2$; in dem rst-Zustand der erste Referenzkondensator $C_{REF1}$ und der zweite Referenzkondensator $C_{REF2}$ auf die Versorgungsspannung $V_{DD}$ vorgeladen sind; in dem $\Phi d$-Zustand der zweite Referenzkondensator $C_{REF2}$ über die erste Diode D1 entladen wird, in dem <Dd1- und dem $\Phi d2$-Zustand der erste Referenzkondensator $C_{REF1}$ über die zweite Diode D2 und eine Kombination der dritten Dioden D3 entladen wird, und am Ende von $\Phi1$, $\Phi d$ und $\Phi d1,2$ das PTAT-Spannungssignal $\Delta V_D$ und das CTAT-Spannungssignal $V_D$ jeweils an dem ersten Referenzkondensator $C_{REF1}$ und an dem zweiten Referenzkondensator $C_{REF2}$ abgetastet werden; und in der $\Phi2$-Phase der achte PTAT-Kreis-Schalter $S_{PTAT8}$ ausgeschaltet ist, während der sechste CTAT-Kreis-Schalter $S_{PTAT6}$ und der siebte PTAT-Kreis-Schalter $S_{PTAT7}$ eingeschaltet sind, sodass das PTAT-Spannungssignal $\Delta V_D$ und das CTAT-Spannungssignal $V_D$ addiert werden und das temperaturunabhängige Referenzsignal an dem ersten Referenzkondensator $C_{REF1}$ und an dem zweiten Referenzkondensator $C_{REF2}$ erzeugt wird; und

nachdem die Abtastphase Fs endet, Eintreten in eine vergleichende Quantisierungsphase $\Phi_{SAR}$ und Teilen von Ladungen unter dem ersten Referenzkondensator $C_{REF1}$, dem zweiten Referenzkondensator $C_{REF2}$ und dem Eingangskondensator CIN über eine Algorithmuslogik der sukzessiven Annäherung, um eine Komparatoreingangsspannung zu erhalten, und Vergleichen von erhaltenen Ergebnissen durch den Komparator, um den nächsten Arbeitszustand des kapazitiven Digital-Analog-Wandlers zu steuern; und Durchführen mehrerer sukzessiver Annäherungsvergleiche, um das abschließend umgewandelte Ausgabesignal zu erhalten.

21. Analog-Digital-Wandler mit integrierter Referenzspannungserzeugung gemäß Anspruch 9 oder 10, wobei der Analog-Digital-Wandler ein Pipeline-Analog-Digital-Wandler ist und der Pipeline-Analog-Digital-Wandler stufenweise in Reihe kaskadierte Wandlungsmodule umfasst, wobei das Wandlungsmodul in jeder Stufe den Abtast- und Halte-Kreis und den kapazitiven Digital-Analog-Wandler umfasst und der Abtast- und Halte-Kreis ein analoges Eingangssignal abtastet und hält, um ein erstes Signal zu erhalten; das Wandlungsmodul in jedem Schritt den Abtast-Halte-Kreis und den kapazitiven Digital-Analog-Wandler umfasst und der Abtast-Halte-Kreis Abtasten und Halten an dem analogen Eingangssignals durchführt, um das erste Signal zu erhalten; der kapazitive Digital-Analog-Wandler das Referenzsignal erzeugt und das zweite Signal in gleichem Verhältnis zu dem Referenzsignal gemäß dem digitalen Rückkopplungsausgabesignal erzeugt und das erste Signal und das zweite Signal differenziert werden, um das Fehlersignal zu erhalten.

22. Kalibrierungsverfahren für einen Analog-Digital-Wandler mit integrierter Referenzspannungserzeugung, das auf den Analog-Digital-Wandler mit integrierter Referenzspannungserzeugung gemäß einem der Ansprüche 10 bis 21 angewendet wird, umfassend:

Schritt 1: Eingeben eines analogen Eingangssignals in den Analog-Digital-Wandler mit integrierter Referenzspannungserzeugung, um ein digitales Ausgabesignal zu erhalten;
Schritt 2: Differenzieren des digitalen Ausgabesignals und eines Idealwerts, um einen Differenzwert zu erhalten; und
Schritt 3: Anpassen eines Referenzkondensators oder einer Entladedauer des kapazitiven Digital-Analog-Wandlers gemäß dem Differenzwert, wodurch das digitale Ausgabesignal kalibriert wird.

23. Kalibrierungsverfahren für den Analog-Digital-Wandler mit integrierter Referenzspannungserzeugung gemäß Anspruch 22, wobei der Idealwert in Schritt 2 ein Verhältnis eines analogen Eingangssignalwerts zu einem Referenzsignalwert ist, dessen Gestaltung erwartet wird.

24. Kalibrierungsverfahren für den Analog-Digital-Wandler mit integrierter Referenzspannungserzeugung gemäß Anspruch 23, wobei der Schritt 3 Folgendes umfasst:

wenn der Differenzwert positiv ist, Erhöhen eines ersten Referenzkondensators $C_{REF1}$ oder eines zweiten Referenzkondensators $C_{REF2}$, bis der Differenzwert Null ist; und
wenn der Differenzwert negativ ist, Verringern des ersten Referenzkondensators $C_{REF1}$ oder des zweiten Referenzkondensators $C_{REF2}$, bis der Differenzwert Null ist.

25. Kalibrierungsverfahren für den Analog-Digital-Wandler mit integrierter Referenzspannungserzeugung gemäß Anspruch 24, wobei der Schritt 3 Folgendes umfasst:

wenn der Differenzwert positiv ist, Verringern einer Entladedauer des ersten Referenzkondensators $C_{REF1}$ oder des zweiten Referenzkondensators $C_{REF2}$, bis der Differenzwert Null ist; und
wenn der Differenzwert positiv ist, Erhöhen der Entladedauer des ersten Referenzkondensators $C_{REF1}$ oder des zweiten Referenzkondensators $C_{REF2}$, bis der Differenzwert Null ist.

**Revendications**

1. Convertisseur analogique-numérique intégré avec génération de tension de référence, comprenant un circuit d'échantillonnage et de maintien, un convertisseur numérique-analogique capacitif et un quantificateur :

ledit circuit d'échantillonnage et de maintien étant configuré pour échantillonner et maintenir un signal d'entrée analogique afin d'obtenir un premier signal ;
ledit convertisseur numérique-analogique capacitif étant configuré pour générer un signal de référence et générer un second signal en proportion égale au signal de référence selon un signal de sortie numérique de rétroaction, et différencier le premier signal et le second signal pour obtenir un signal d'erreur ; et
ledit quantificateur étant configuré pour numériser le signal d'erreur afin d'obtenir un signal de sortie numérique ;
ledit convertisseur numérique-analogique capacitif comprenant un circuit CTAT sur la base d'une diode à polarisation capacitive, le circuit CTAT basé sur la diode à polarisation capacitive générant une tension CTAT $V_D$ qui diminue avec l'augmentation de la température ;
ledit circuit CTAT basé sur la diode à polarisation capacitive comprenant un premier commutateur de circuit CTAT $S_{CTAT1}$, une branche de diode CTAT et une branche de condensateur CTAT, une extrémité du premier commutateur de circuit CTAT $S_{CTAT1}$ étant connectée respectivement à une extrémité de la branche de diode CTAT et à une extrémité de la branche de condensateur CTAT, et l'autre extrémité de la branche de diode CTAT et l'autre extrémité de la branche de condensateur CTAT étant toutes deux mises à la terre ; et l'autre extrémité du premier commutateur de circuit CTAT $S_{CTAT1}$ étant connectée à une alimentation,
ladite branche de diode CTAT comprenant une première diode D1 et un deuxième commutateur de circuit CTAT $S_{CTAT2}$ connecté à la première diode D1 ;
ladite branche de condensateur CTAT comprenant un second condensateur de référence CREF2 ;
ledit second condensateur de référence $C_{REF2}$ étant préchargé à une tension d'alimentation $V_{DD}$ à travers le premier commutateur de circuit CTAT $S_{CAT1}$, puis le premier commutateur de circuit CTAT $S_{CAT1}$ étant désactivé, ledit deuxième commutateur de circuit CTAT $S_{CTAT2}$ étant activé et ledit second condensateur de référence $C_{REF2}$ étant déchargé à travers la première diode D1 ; et lorsqu'une tension résiduelle sur le second condensateur de référence $C_{REF2}$ diminue avec l'augmentation de la température dans une durée de décharge fixe, ladite tension résiduelle étant la tension CTAT $V_D$,

ledit convertisseur numérique-analogique capacitif comprenant un circuit PTAT, qui comprend un premier circuit de diode à polarisation capacitive et un second circuit de diode à polarisation capacitive,

un premier condensateur de référence $C_{REF1}$ du premier circuit à diode à polarisation capacitive étant préchargé à la tension d'alimentation $V_{DD}$ à travers un premier commutateur de circuit PTAT $S_{PTAT1}$, puis le premier commutateur de circuit PTAT $S_{PTAT1}$ étant désactivé et un troisième commutateur de circuit PTAT $S_{PTAT3}$ étant activé, et ledit premier condensateur de référence $C_{REF1}$ du premier circuit à diode à polarisation capacitive étant déchargé à travers une deuxième diode D2 pour obtenir une première tension résiduelle $V_{D1}$,

un premier condensateur de référence $C_{REF1}$ du second circuit à diode à polarisation capacitive étant préchargé à la tension d'alimentation $V_{DD}$ par l'intermédiaire d'un deuxième commutateur de circuit PTAT $S_{PTAT2}$, puis ledit deuxième commutateur de circuit PTAT $S_{PTAT2}$ étant désactivé, un quatrième commutateur de circuit PTAT $S_{PTAT4}$ étant activé, et ledit premier condensateur de référence $C_{REF1}$ du second circuit à diode à polarisation capacitive étant déchargé par l'intermédiaire d'une combinaison de diodes PTAT,

comprenant p troisièmes diodes D3 connectées en parallèle,

p étant supérieur à 1, pour obtenir une seconde tension résiduelle $V_{D2}$.

2. Convertisseur analogique-numérique intégré avec génération de tension de référence selon la revendication 1,

ledit circuit CTAT basé sur la diode à polarisation capacitive et ledit circuit PTAT basé sur la diode à polarisation capacitive générant conjointement le signal de référence, et ledit signal de référence étant indépendant de la température.

3. Convertisseur analogique-numérique intégré avec génération de tension de référence selon la revendication 2, ledit circuit PTAT basé sur la diode à polarisation capacitive générant une tension PTAT $\Delta V_D$ qui augmente avec l'augmentation de la température, ladite tension CTAT $V_D$ et ladite tension PTAT $\Delta V_D$ étant combinées et ajoutées pour générer une tension de référence $V_{REF}$ du signal de référence, $V_{REF} = \alpha \Delta V_D + V_D$, $\alpha$ étant un facteur d'échelle, et une valeur du facteur d'échelle $\alpha$ rendant la tension de référence $V_{REF}$ indépendante de la température.

rature.

4. Convertisseur analogique-numérique intégré avec génération de tension de référence selon la revendication 3, ledit circuit PTAT basé sur la diode à polarisation capacitive comprenant le premier circuit à diode à polarisation capacitive et le second circuit à diode à polarisation capacitive, ledit premier circuit à diode à polarisation capacitive comprenant le premier commutateur de circuit PTAT $S_{PTAT1}$, une première branche de diode PTAT et une première branche de condensateur PTAT, une extrémité du premier commutateur de circuit PTAT $S_{PTAT1}$ étant respectivement connectée à une extrémité de la première branche de diode PTAT et à une extrémité de la première branche de condensateur PTAT, et l'autre extrémité de la première branche de diode PTAT et l'autre extrémité de la première branche de condensateur PTAT étant toutes deux mises à la terre ; et l'autre extrémité du premier commutateur de circuit PTAT $S_{PTAT1}$ étant connectée à l'alimentation ; et ledit second circuit de diode à polarisation capacitive comprenant le deuxième commutateur de circuit PTAT $S_{PTAT2}$, une seconde branche de diode PTAT et une seconde branche de condensateur PTAT, une extrémité du deuxième commutateur de circuit PTAT $S_{PTAT2}$ étant connectée respectivement à une extrémité de la seconde branche de diode PTAT et à une extrémité de la seconde branche de condensateur PTAT, et l'autre extrémité de la seconde branche de diode PTAT et l'autre extrémité de la seconde branche de condensateur PTAT étant toutes deux mises à la terre ; et l'autre extrémité du deuxième commutateur de circuit PTAT $S_{PTAT2}$ étant connectée à l'alimentation.

5. Convertisseur analogique-numérique intégré avec génération de tension de référence selon la revendication 4, lorsque le signal de sortie numérique est une sortie numérique de 1 bit, ladite branche de condensateur CTAT comprenant le second condensateur de référence $C_{REF2}$.

6. Convertisseur analogique-numérique intégré avec génération de tension de référence selon la revendication 4, lorsque le signal de sortie numérique est une sortie de N bits, et que $N$ est supérieur à 1, ladite branche de condensateur CTAT comprenant N secondes branches de condensateur parallèles, chaque seconde branche de condensateur comprend un second condensateur de référence $C_{REF2}$ et un deuxième commutateur de référence $S_{REF2}$ connecté au second condensateur de référence $C_{REF2}$.

7. Convertisseur analogique-numérique intégré avec génération de tension de référence selon la revendication 5 ou 6, ladite première branche de diode PTAT comprenant la deuxième diode D2 et le troisième commutateur de circuit PTAT $S_{PTAT3}$ connecté à la deuxième diode D2.

8. Convertisseur analogique-numérique intégré avec génération de tension de référence selon la revendication 7, ladite seconde branche de diode PTAT comprenant le quatrième commutateur de circuit PTAT $S_{PTAT4}$ et la combinaison de diodes PTAT connectée au quatrième commutateur de circuit PTAT $S_{PTAT4}$.

9. Convertisseur analogique-numérique intégré avec génération de tension de référence selon la revendication 8, lorsque le signal de sortie numérique est une sortie numérique de 1 bit, ladite première branche de condensateur PTAT et ladite seconde branche de condensateur PTAT comprenant toutes les deux un premier condensateur de référence $C_{REF1}$.

10. Convertisseur analogique-numérique intégré avec génération de tension de référence selon la revendication 8, lorsque le signal de sortie numérique est une sortie de $N$ bits et que N est supérieur à 1, ladite première branche de condensateur PTAT et ladite seconde branche de condensateur PTAT comprenant toutes les deux N premières branches de condensateur parallèles, chaque première branche de condensateur comprenant un premier condensateur de référence $C_{REF1}$ et un premier commutateur de référence $S_{REF1}$ connecté au premier condensateur de référence CREFI.

11. Convertisseur analogique-numérique intégré avec génération de tension de référence selon la revendication 10, une différence de tension $V_{D1}-V_{D2}$ entre la première tension résiduelle $V_{D1}$ et la seconde tension résiduelle $V_{D2}$ augmentant avec l'augmentation de la température, et ladite différence de tension étant la tension PTAT $\Delta V_D$.

12. Convertisseur analogique-numérique intégré avec génération de tension de référence selon la revendication 11, ledit premier commutateur de circuit CTAT $S_{CTAT1}$, lesdites séquences de synchronisation de commande du premier commutateur de circuit PTAT $S_{PTAT1}$ et dudit deuxième commutateur de circuit PTAT $S_{PTAT2}$ étant les mêmes.

13. Convertisseur analogique-numérique intégré avec génération de tension de référence selon la revendication 12, lesdites séquences de synchronisation de commande du deuxième commutateur de circuit CTAT $S_{CTAT2}$, du troisième commutateur de circuit PTAT $S_{PTAT3}$ et du quatrième commutateur de circuit PTAT $S_{PTAT4}$ étant les mêmes, et un rapport d'une surface de la deuxième diode D2 sur une surface de la combinaison de diodes PTAT étant fixé à *1:p*, et p

étant supérieur à 1.

14. Convertisseur analogique-numérique intégré avec génération de tension de référence selon la revendication 13, lesdites séquences de synchronisation de commande du deuxième commutateur de circuit CTAT $S_{CTAT2}$ et du troisième commutateur de circuit PTAT $S_{PTAT3}$ étant les mêmes, une surface de la deuxième diode D2 étant égale à une surface de la combinaison de diodes PTAT, lesdits temps de démarrage de l'activation du troisième commutateur de circuit PTAT $S_{PTAT3}$ et du quatrième commutateur de circuit PTAT $S_{PTAT4}$ étant les mêmes, un rapport de durées d'activation étant de 1:*p,* et *p* étant supérieur à 1.

15. Convertisseur analogique-numérique intégré avec génération de tension de référence selon la revendication 9 ou 10, ledit convertisseur analogique-numérique étant un convertisseur analogique-numérique Delta-Sigma, ledit convertisseur analogique-numérique Delta-Sigma comprenant un modulateur Delta-Sigma, ledit modulateur Delta-Sigma comprenant le convertisseur numérique-analogique capacitif et un intégrateur de premier ordre, ledit convertisseur numérique-analogique capacitif générant la tension CTAT $V_D$ et la tension PTAT $\Delta V_D$, ladite tension CTAT $V_D$ et ladite tension PTAT $\Delta V_D$ étant ajoutées et combinées par l'intégrateur de premier ordre pour obtenir une référence de signal de référence $V_{REF} = \alpha \Delta V_D + V_D$, $\alpha = C_{REF1}/C_{REF2}$.

16. Convertisseur analogique-numérique intégré avec génération de tension de référence selon la revendication 15, ledit intégrateur de premier ordre comprenant un condensateur d'intégration $C_{INT}$, et une séquence de synchronisation de commande du modulateur Delta-Sigma comprenant : la réalisation d'un échantillonnage de signal d'un signal d'entrée $V_{IN}$ dans une période d'échantillonnage $\Phi1$ et la réalisation d'un transfert de signal et d'une intégration dans une période d'intégration $\Phi2$ ; pour une branche de signal de référence, ladite période d'échantillonnage $\Phi1$ étant divisée en deux parties : rst et $\Phi3$, dans l'état rst, ledit premier condensateur de référence $C_{REF1}$ et ledit second condensateur de référence $C_{REF2}$ étant préchargés à la tension d'alimentation ; dans l'état $\Phi3$, ledit second condensateur de référence $C_{REF2}$ étant déchargé à travers la première diode D1, ledit premier condensateur de référence $C_{REF1}$ étant déchargé à travers la deuxième diode D2 et la combinaison de diodes PTAT, et ledit signal de référence étant échantillonné au niveau du premier condensateur de référence $C_{REF1}$ et du second condensateur de référence $C_{REF2}$ à la fin de $\varphi3$ et $\varphi1$ ; et dans une phase d'intégration $\Phi2$, des charges sur le premier condensateur de référence $C_{REF1}$ et le second condensateur de référence

$C_{REF2}$ étant transférées au condensateur d'intégration $C_{INT}$.

**17.** Convertisseur analogique-numérique intégré avec génération de tension de référence selon la revendication 16, lorsque le modulateur Delta-Sigma émet en sortie un flux de code BS de 1 bit, $+/-V_{REF}$ étant généré selon le flux de code BS de 1 bit de sorti, qui est utilisé pour l'équilibrage avec le signal d'entrée $V_{IN}$, et une valeur moyenne du flux de code BS étant $V_{IN}/V_{REF}$.

**18.** Convertisseur analogique-numérique intégré avec génération de tension de référence selon la revendication 10, ledit convertisseur analogique-numérique étant un convertisseur analogique-numérique à registre d'approximation successif à partage de charge, ledit convertisseur analogique-numérique à registre d'approximation successif comprenant un condensateur d'entrée CIN, le convertisseur numérique-analogique capacitif et un comparateur, et ledit convertisseur numérique-analogique capacitif échantillonnant le signal de référence indépendant de la température sur le premier condensateur de référence de N bits $C_{REF1}$ et le second condensateur de référence $C_{REF2}$ dans un étage d'échantillonnage, et générant un signal de commande de rétroaction en proportion égale au signal de référence selon les résultats de comparateur dans un étage de comparaison.

**19.** Convertisseur analogique-numérique intégré avec génération de tension de référence selon la revendication 18, dans le convertisseur numérique-analogique capacitif, une extrémité du premier commutateur de circuit CTAT $S_{CTAT1}$ du circuit CTAT basé sur la diode à polarisation capacitive étant également connectée à un sixième commutateur de circuit CTAT $S_{CTAT6}$, et lorsque le signal de sortie numérique est une sortie numérique de *N* bits, et *N* est supérieur à 1, ladite branche de condensateur CTAT comprenant *N* secondes branches de condensateur parallèles, ladite seconde branche de condensateur comprenant le second condensateur de référence $C_{REF2}$, et le deuxième commutateur de référence $S_{REF2}$ connecté au second condensateur de référence $C_{REF2}$, et comprenant en outre un quatrième commutateur de référence $S_{REF4}$ connecté au second condensateur de référence $C_{REF2}$, et ledit quatrième commutateur de référence $S_{REF4}$ étant connecté à une MSB ou à une LSB ; et dans le circuit PTAT basé sur la diode à polarisation capacitive, une extrémité du premier commutateur de circuit PTAT $S_{PTAT1}$ étant également connectée à un septième commutateur de circuit PTAT $S_{PTAT7}$, une extrémité du deuxième commutateur de circuit PTAT $S_{PTAT2}$ étant connectée au septième commutateur de circuit PTAT $S_{PTAT7}$, ladite première branche de condensateur PTAT et ladite seconde branche de condensateur PTAT comprenant toutes les deux N première branche de condensateur parallèle, ladite première branche de condensateur comprenant le premier condensateur de référence $C_{REF1}$, et ledit premier commutateur de référence $S_{REF1}$ connecté au premier condensateur de référence $C_{REF1}$, et comprenant en outre un troisième commutateur de référence $S_{REF3}$ connecté au premier condensateur de référence $C_{REF1}$, et ledit troisième commutateur de référence $S_{REF3}$ étant connecté au MSB ou au LSB ; ladite seconde branche de condensateur PTAT comprenant en outre un huitième commutateur de circuit PTAT $S_{PTAT8}$, une extrémité du huitième commutateur de circuit PTAT $S_{PTAT8}$ étant connectée aux N premières branches de condensateur parallèles, et l'autre extrémité du huitième commutateur de circuit PTAT $S_{PTAT8}$ étant mise à la terre ; et une extrémité du huitième commutateur de circuit PTAT $S_{PTAT8}$ étant également connectée au sixième commutateur de circuit CTAT $S_{CTAT6}$.

**20.** Convertisseur analogique-numérique intégré avec génération de tension de référence selon la revendication 19, une séquence de synchronisation de commande du convertisseur analogique-numérique à registre d'approximation successif à partage de charge comprenant : l'échantillonnage et le maintien d'un signal d'entrée sur un condensateur d'entrée CIN, et le maintien d'une tension de référence du signal de référence sur le premier condensateur de référence $C_{REF1}$ et le second condensateur de référence $C_{REF2}$ ; la différenciation des signaux d'entrée INP et INN pour réaliser un échantillonnage de signal maintenu sur le condensateur d'entrée CIN lorsqu'une phase d'échantillonnage Fs est élevée, et pour la branche de signal de référence, l'accès au premier condensateur de référence $C_{REF1}$ du circuit à la phase d'échantillonnage Fs par le premier commutateur de référence $S_{REF1}$ et le troisième commutateur de référence $S_{REF3}$, et l'accès au second condensateur de référence $C_{REF2}$ du circuit à la phase d'échantillonnage Fs à travers le deuxième commutateur de référence $S_{REF2}$ et le quatrième commutateur de référence $S_{REF4}$ dans le circuit pour générer le signal de référence ; ladite phase d'échantillonnage Fs pouvant être séparée en deux parties : une phase $\Phi 1$ et une phase $\Phi 2$, ladite phase $\Phi 1$ réalisant la génération d'un signal de tension PTAT $\Delta V_D$ qui est positivement lié à la température et un signal de tension CTAT $V_D$ qui est négativement lié à la température ; et ladite phase $\varphi 2$ réalisant une addition proportionnelle du signal de tension PTAT $\Delta V_D$ et du signal de tension CTAT $V_D$ pour obtenir un signal de référence $\alpha \Delta V_D + V_D$ qui est indépendant de la température ; pour la génération du signal de tension PTAT $\Delta V_D$ et du signal de tension CTAT $V_D$, ladite phase Φ1 étant en outre divisée en deux sous-phases : rst et Φd/Φd1,2 ; dans l'état rst, ledit premier condensateur de référence $C_{REF1}$ et ledit second condensateur de référence $C_{REF2}$ étant préchargés à la tension d'alimentation $V_{DD}$ ; dans l'état Φd, ledit second condensateur de référence $C_{REF2}$ étant déchargé à travers la première diode D1, dans les états Φd1 et Φd2, ledit premier condensateur de référence $C_{REF1}$ étant déchargé à travers la deuxième diode D2 et une combinaison des troisièmes diodes D3, et à la fin de Φ1, Φd et Φd1,2, ledit signal de tension PTAT $\Delta V_D$ et ledit signal de tension CTAT $V_D$ étant respectivement échantillonnés au niveau du premier condensateur de référence $C_{REF1}$ et du second condensateur de référence $C_{REF2}$ ; et à la phase Φ2, ledit huitième commutateur de circuit PTAT $S_{PTAT8}$ étant désactivé, pendant que le sixième commutateur de circuit CTAT $S_{PTAT6}$ et le septième commutateur de circuit PTAT $S_{PTAT7}$ sont activés, afin que le signal de tension PTAT $\Delta V_D$ et le signal de tension CTAT $V_D$ soient ajoutés, et ledit signal de référence indépendant de la température étant généré au niveau du premier condensateur de référence $C_{REF1}$ et du second condensateur de référence $C_{REF2}$ ; et après la fin de la phase d'échantillonnage Fs, l'entrée dans une phase de quantification comparative $\Phi_{SAR}$, et le partage des charges entre le premier condensateur de référence $C_{REF1}$, le second condensateur de référence $C_{REF2}$ et le condensateur d'entrée CIN par l'intermédiaire d'une logique d'algorithme d'approximation successive pour obtenir une tension d'entrée de comparateur, et la comparaison, par le comparateur, des résultats obtenus pour commander l'état de fonctionnement suivant du convertisseur numérique-analogique capacitif ; et la réalisation de multiples comparaisons d'approximation successive pour obtenir le signal de sortie finalement converti.

21. Convertisseur analogique-numérique intégré avec génération de tension de référence selon la revendication 9 ou 10, ledit convertisseur analogique-numérique étant un convertisseur analogique-numérique en pipeline, ledit convertisseur analogique-numérique en pipeline comprenant des modules de conversion montés en cascade en série étage par étage, ledit module de conversion dans chaque étage comprenant le circuit d'échantillonnage et de maintien et le convertisseur numérique-analogique capacitif, et ledit circuit d'échantillonnage et de maintien échantillonnant et maintenant un signal d'entrée analogique pour obtenir un premier signal ; ledit module de conversion dans chaque étage comprenant ledit circuit d'échantillonnage et de maintien et ledit convertisseur numérique-analogique capacitif, ledit circuit d'échantillonnage et de maintien réalisant l'échantillonnage et le maintien sur le signal d'entrée analogique pour obtenir le premier signal ; ledit convertisseur numérique-analogique capacitif générant le signal de référence et générant le second signal en proportion égale au signal de référence selon le signal de sortie numérique de rétroaction, ledit premier signal et ledit second signal étant différenciés pour obtenir le signal d'erreur.

22. Procédé d'étalonnage pour un convertisseur analogique-numérique intégré avec génération de tension de référence appliqué au convertisseur analogique-numérique intégré avec génération de tension de référence selon l'une quelconque des revendications 10 à 21, comprenant :

    étape 1 : entrée d'un signal d'entrée analogique dans le convertisseur analogique-numérique intégré avec génération de tension de référence pour obtenir un signal de sortie numérique ;
    étape 2 : différenciation du signal de sortie numérique et d'une valeur idéale pour obtenir une valeur de différence ; et
    étape 3 : réglage d'un condensateur de référence ou d'une durée de décharge du convertisseur numérique-analogique capacitif selon la valeur de différence, étalonnant ainsi le signal de sortie numérique.

23. Procédé d'étalonnage pour le convertisseur analogique-numérique intégré avec génération de tension de référence selon la revendication 22, ladite valeur idéale à l'étape 2 étant un rapport d'une valeur de signal d'entrée analogique sur une valeur de signal de référence censée être conçue.

24. Procédé d'étalonnage pour le convertisseur analogique-numérique intégré avec génération de tension de référence selon la revendication 23, ladite étape 3 comprenant :

    lorsque la valeur de différence est positive, l'augmentation d'un premier condensateur de référence $C_{REF1}$ ou d'un second condensateur de référence $C_{REF2}$ jusqu'à ce que la valeur de différence soit nulle ; et
    lorsque la valeur de différence est négative, la diminution du premier condensateur de référence $C_{REF1}$ ou du second condensateur de référence $C_{REF2}$ jusqu'à ce que la valeur de différence soit nulle.

25. Procédé d'étalonnage pour le convertisseur analogique-numérique intégré avec génération de tension de référence selon la revendication 24, ladite étape 3 comprenant :

    lorsque la valeur de différence est positive, la diminution d'une durée de décharge du premier condensateur de référence $C_{REF1}$ ou du second condensateur de référence $C_{REF2}$ jusqu'à ce que la valeur de différence soit nulle ; et lorsque la valeur de différence est positive, l'augmentation d'une durée de décharge du premier condensateur de référence $C_{REF1}$ ou du second condensateur de référence $C_{REF2}$ jusqu'à ce que la valeur de différence soit nulle.

FIG. 1

FIG. 2

FIG. 3

FIG. 4

FIG. 5

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200373940 A